# EUROPEAN PATENT SPECIFICATION

(11) **EP 3 526 899 B1**
(45) Date of publication and mention of the grant of the patent: **18.08.2021**
(21) Application number: 17777172.2
(22) Date of filing: 30.08.2017
(51) Int. Cl.: H03M 13/11, H03M 13/29

(54) **DECODING OF LOW-DENSITY PARITY-CHECK CONVOLUTIONAL TURBO CODES**
DECODIERUNG VON FALTUNGSTURBOCODES ZUR PARITÄTSPRÜFUNG MIT NIEDRIGER DICHTE
DÉCODAGE DE TURBO-CODES CONVOLUTIFS DE CONTRÔLE DE PARITÉ DE FAIBLE DENSITÉ

(43) Date of publication of application: 21.08.2019
(73) Proprietor: Huawei Technologies Co., Ltd., Longgang District Shenzhen, Guangdong 518129 (CN)
(72) Inventor: MANFREDI, Marco, 80992 Munich (DE); CANNALIRE, Giacomo, 80992 Munich (DE); MAZZUCCO, Christian, 80992 Munich (DE)
(74) Representative: Pfenning, Meinig & Partner mbB
(86) International application number: PCT/EP2017/071793
(87) International publication number: WO 2019/042543

(56) References cited:
- US-A1- 2013 254 633
- CORAZZA G E ET AL: "Latency constrained protograph-based LDPC convolutional codes", PROC., 6TH IEEE INTERNATIONAL SYMPOSIUM ON TURBO CODES AND ITERATIVE INFORMATION PROCESSING, ISTC 2010, 6 September 2010 (2010-09-06), pages 6-10, XP031783822, ISBN: 978-1-4244-6744-0
- PUSANE A E ET AL: "Implementation aspects of LDPC convolutional codes", IEEE TRANSACTIONS ON COMMUNICATIONS, IEEE SERVICE CENTER, PISCATAWAY, NJ. USA, vol. 56, no. 7, 1 July 2008 (2008-07-01), pages 1060-1069, XP011231533, ISSN: 0090-6778, DOI: 10.1109/TCOMM.2008.050519
- ZHENGANG CHEN ET AL: "High Throughput Parallel Decoder Design for LDPC Convolutional Codes", PROC., 4TH IEEE INTERNATIONAL CONFERENCE ON CIRCUITS AND SYSTEMS FOR COMMUNICATIONS, ICCSC 2008, 26 May 2008 (2008-05-26), pages 35-39, XP031268649, ISBN: 978-1-4244-1707-0
- Eran Pisek ET AL: "Capacity-Approaching TQC-LDPC Convolutional Codes Enabling Power-Efficient Decoders", IEEE Transactions on Communications, 10 October 2016 (2016-10-10), pages 1-13, XP055449345, DOI: 10.1109/TCOMM.2016.2616142 Retrieved from the Internet: URL:http://ieeexplore.ieee.org/ielx7/26/78 18052/07587400.pdf?tp=&arnumber=7587400&is number=7818052 [retrieved on 2018-02-08]
- PISEK ERAN ET AL: "Trellis-Based QC-LDPC Convolutional Codes Enabling Low Power Decoders", IEEE TRANSACTIONS ON COMMUNICATIONS, IEEE SERVICE CENTER, PISCATAWAY, NJ. USA, vol. 63, no. 6, 1 June 2015 (2015-06-01), pages 1939-1951, XP011584363, ISSN: 0090-6778, DOI: 10.1109/TCOMM.2015.2424434 [retrieved on 2015-06-12]

## Description

### FIELD

The present disclosure relates to low-density parity-check convolutional turbo codes (LDPC-CTCs). In particular, the present disclosure relates to a procedure for decoding LDPC-CTCs.

### BACKGROUND

LDPC-CCs suggested by A. J. Felstrom and K. Zigangirov, "Time-varying periodic convolutional codes with low density parity-check matrix", IEEE TRANSACTIONS ON INFORMATION THEORY, vol. 45, No. 6, pp. 2181-2191, Sept. 1999, are based on a binary parity-check matrix which has a column weight that is not equal to '1'. For this reason, it may be unfeasible to employ the parallel layered decoding algorithm already used for LDPC block codes (LDPC-BCs), as there can be conflicts regarding the reading and writing of the received signal vector.

Rather, decoding of LDPC-CCs suggested by A. J. Felstrom and K. Zigangirov may be carried-out based on:
- serial layered decoding, which decodes the same information sequence, and parallel layered decoding, which decodes different information sequences (this provides for good performance/fast convergence of the belief propagation algorithm, but suffers from high decoding latency); or
- parallel layered decoding, which decodes the same information sequence (this provides for low decoding latency but does not achieve good performance - slow convergence of the belief propagation algorithm).

Accordingly, there is a demand for more advanced decoding procedures.

CORAZZA G E ET AL.:" Latency constrained protograph-based LDPC convolutional codes", PROC., 6TH IEEE International Symposium on Turbo Codes & Iterative Information Processing, ISTC 2010, 6 September 2010, pages 6-10, XP031783822, ISBN: 978-1-4244-6744-0, discloses the performance of regular LDPC-CC with the windowed decoding scheme, and in particular, the class of LDPC-CC proposed in the literature with good belief propagation performance is ill-suited for windowed decoding.

US 2013/254633 A1 discloses a decoder including a control unit and a decoding unit. The control unit determines a window size applied to a first target frame to be a first value and determines a window size applied to a second target frame different from the first target frame to be a second value different from the first value. The decoding unit carries out windowed decoding of a spatially coupled code on the first target frame with the window size set to the first value and carries out windowed decoding of a spatially coupled code on the second target frame with the window size set to the second value.

### SUMMARY

The present invention is as defined in the appended independent claims. In the following, an improved procedure for decoding LDPC-CTCs is described. To exploit the small structural latency of LDPC-CTC, the inner core of the decoder may be based on a simplified version of the standard belief propagation algorithm (BPA) (which is usually adopted in LDPC-BC), but the management of the IN-OUT memories may be modified.

E.g., if a time slot (TS) is the period to receive a block of wc (rate=b/c) bits (where *w* is the number of "parallel" LDPC-CCs on which the LDPC-CTC is based), a single decoding iteration may be performed starting from the last new log likelihood ratios (LLRs) acquired in the current TS and involve updating all LLRs up to the last LLRs memorized (e.g., LLRs of several code periods, depending on the memory depth). As the number of rows to iterate is fixed, the processing time is fixed. Old LLRs in the memory are iterated more times and may be dropped out from the memory according to latency/performance as required.

In this decoding procedure, which may be referred to as a "sliding-window" decoding procedure, the latency of the decoding process can be modified by the decoder in a way that is transparent to the encoder and the size of the memory used during decoding can be adapted by changing the number of iterations LLRs that are kept in the memory.

According to a first aspect of the present invention, there is provided a decoder for decoding a LDPC-CTC, the decoder being configured to determine, based on a received signal, statistical values corresponding to information and parity bits of an encoded information bit sequence, start a new decoding iteration if a number of determined statistical values equals or exceeds a threshold, wherein a decoding iteration includes updating the determined statistical values based on actual determined statistical values and statistical values from a previous decoding iteration stored in a memory of the decoder, replace a stored statistical value stored in the memory with an updated statistical value, wherein the updated statistical value is kept in the memory for a number of succeeding decoding iterations, and decode the information bits to which the updated stored statistical values correspond.

In this regard, it is noted that the term "decoder" as used throughout the description and claims in particular refers to hardware, or a combination of hardware and software which implements a decoding procedure. In particular the decoder may include a processor or a processing circuit configured to perform the decoding operations or steps. Moreover, the term "received signal" as used throughout the description and claims in particular refers to a channel output, e.g., an electromagnetic signal such as a modulated carrier wave. Furthermore, the term "statistical value" as used throughout the description and claims in particular refers to reliability values corresponding to the received information and parity bits, wherein a reliability value (e.g., a likelihood, likelihood ratio, or log likelihood ratio) indicates the reliability of making a correct decision if mapping (a part of) the received signal to a particular bit value.

This "sliding-window" decoding procedure provides for low latency and reduces memory requirements. In fact, the latency of the decoding procedure can be instantly/independently modified by the decoder (during decoding) based on performance considerations, without a need to provide feedback/communicate a change of the encoding matrix to the encoder. Moreover, unlike known decoding procedures for LDPC-BCs, the size of the parity check matrix of the LDPC-CTC is substantially independent of code-word length. Furthermore, these benefits can be achieved without (substantially) increasing the hardware complexity of the decoder as compared to a decoder for LDPC BCs.

In a first possible implementation form of the decoder according to the first aspect, the decoder is further configured to remove/overwrite the updated stored statistical values from/in the memory of the decoder after the succeeding decoding iterations have been performed and the information bits corresponding to the updated stored statistical value have been decoded.

Hence, the overall need for memory space can be reduced by re-using memory space freed from updated stored statistical values that drop out of memory.

In a second possible implementation form of the decoder according to the first aspect, the decoder is further configured to adapt the number of succeeding decoding operations for which the updated statistical values are kept in the memory of the decoder.

Hence, the usage of memory space can be reduced by reducing the number of TSs for which statistical values are kept in the memory.

In a third possible implementation form of the decoder according to the first aspect, the decoder is further configured to decrease the number of succeeding decoding operations for which the updated statistical values are kept in the memory of the decoder in response to a request to reduce a latency of the decoding operation.

Thus, the latency of the decoding procedure can be reduced.

In a fourth possible implementation form of the decoder according to the first aspect, the decoder is further configured to increase the number of succeeding decoding operations for which the updated statistical values are kept in the memory of the decoder in response to a request to reduce an error rate of the decoding operation.

Thus, the performance of the decoding procedure can be improved.

In a fifth possible implementation form of the decoder according to the first aspect, the threshold equals the number of information and parity bits of one layer of the LDPC-CTC.

In this regard, it is noted that the term "layer" as used throughout the description and claims in particular refers to one row for each LDPC-CC matrix on which the LDPC-CTC is based.

In a sixth possible implementation form of the decoder according to the first aspect, updating the statistical values based on the statistical values and statistical values from a previous decoding iteration stored in a memory of the decoder includes parallelly updating different sets of statistical values assigned to different parity bits.

Hence, performance of the decoding procedure can be further improved.

Furthermore, the implementation forms of the decoder may include, but are not limited to, one or more processor, one or more application specific integrated circuit (ASIC) and/or one or more field programmable gate array (FPGA). Implementation forms of the decoder may also include other conventional and/or customized hardware such as software programmable processors.

According to a second aspect of the present invention, there is provided a method of decoding a LDPC-CTC the method comprising determining, based on a received signal, statistical values corresponding to information and parity bits of an encoded information bit sequence, starting a new decoding iteration if a number of determined statistical values equals or exceeds a threshold, wherein a decoding iteration includes updating the determined statistical values based on actual determined statistical values and statistical values from a previous decoding iteration, replacing a stored statistical value stored in the memory with an updated statistical value, wherein the updated statistical value is kept in the memory for a number of succeeding decoding iterations, and decoding the information bits to which the updated stored statistical values correspond.

Thus, as indicated above, the latency of the decoding procedure can be instantly/independently modified (during decoding) based on performance considerations, without a need to adapt the encoding procedure. Moreover, unlike known decoding procedures for LDPC-BCs, the size of the parity check matrix of the LDPC-CTC is substantially independent of code-word length.

In a first possible implementation form of the method according to the second aspect, the method further comprises removing/overwriting the updated stored statistical values from/in the memory after the succeeding decoding iterations have been performed and the information bits corresponding to the updated stored statistical value have been decoded.

Hence, the overall need for memory space can be reduced by re-using memory space freed from updated stored statistical values that drop out of memory.

In a second possible implementation form of the method according to the second aspect, the method further comprises adapting the number of succeeding decoding operations for which the updated statistical values are kept in the memory.

Hence, the usage of memory space can be reduced by reducing the number of decoding iterations for which statistical values are kept in the memory.

In a third possible implementation form of the method according to the second aspect, the method further comprises decreasing the number of succeeding decoding operations for which the updated statistical values are kept in the memory in response to a request to reduce a latency of the decoding operation.

Thus, the latency introduced by decoding can be reduced.

In a fourth possible implementation form of the method according to the second aspect, the method further comprises increasing the number of succeeding decoding operations for which the updated statistical values are kept in the memory in response to a request to reduce an error rate of the decoding operation.

Thus, decoding performance can be improved.

In a fifth possible implementation form of the method according to the second aspect, the threshold equals the number of information and parity bits of one layer of the LDPC-CTC.

Thus, a decoding operation starts as soon as all bits of the first layer are received.

In a sixth possible implementation form of the method according to the second aspect, updating the statistical values based on the statistical values and statistical values from a previous decoding iteration stored in a memory of the decoder includes parallelly updating different sets of statistical values assigned to different parity bits.

Hence, decoding performance can be further improved.

Moreover, it will be appreciated that method steps and decoder features may be interchanged in many ways. In particular, the features of the disclosed decoder can be part of the method and the method steps can be implemented by the decoder.

According to a third aspect of the present invention, there is provided a machine-readable medium comprising machine-readable instructions which when carried-out by the machine cause the machine to perform the method according to a second aspect or any one of the implementation forms of the method according to a second aspect.

### BRIEF DESCRIPTION OF THE DRAWINGS

Fig. 1 illustrates horizontal scheduling on a simplex matrix.
Fig. 2 shows a block diagram of a calculus or decoding unit for a turbo decoding message passing procedure based on the normalized min sum algorithm.
Fig. 3 shows a block diagram of a digital communication system in which the decoding procedure of the present invention may be implemented.
Fig. 4 illustrates an exemplary encoding procedure which may be performed by an LDPC-CTC encoder of the digital communication system of Fig. 3.
Fig. 5 illustrates an example of the encoding procedure for an LDPC-CTC with rate *R* = *kᵢ*/*n_{c}* = 3/4.
Fig. 6 shows an LDPC-CTC seed matrix portion according to the example of Fig. 5.
Fig. 7 illustrates a block-based decoding procedure.
Fig. 8 illustrates a slot-based decoding procedure.
Fig. 9 illustrates a "sliding-window" decoding procedure which may be performed by an LDPC-CTC decoder of the digital communication system of Fig. 3.
Fig. 10 shows a flow chart of steps of the decoding procedure.

### DETAILED DESCRIPTION

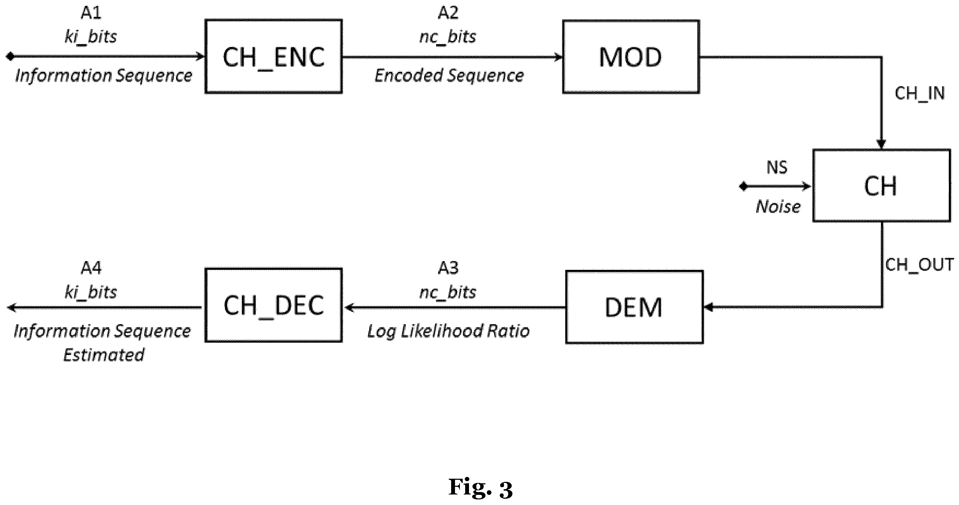

The following provides a non-limiting example of an encoding/decoding procedure for LDPC-CTC codes with is described with reference to Fig. 3 to Fig. 12.

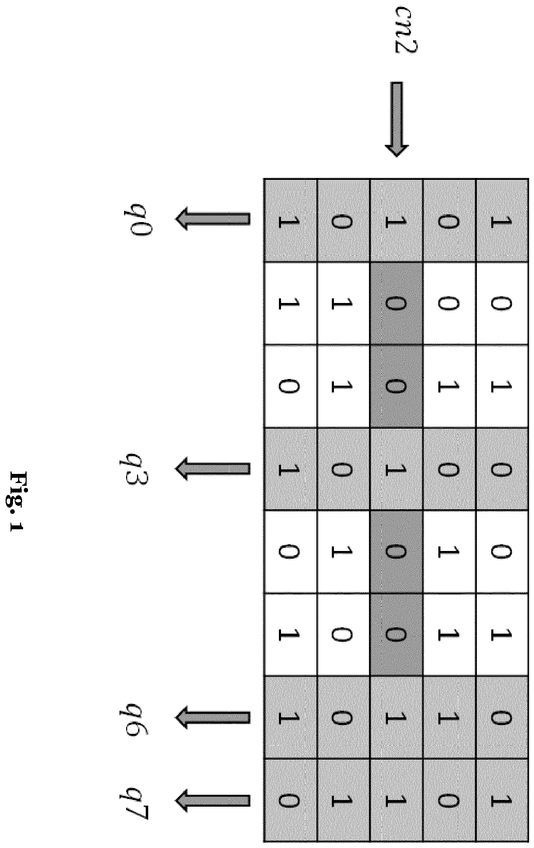

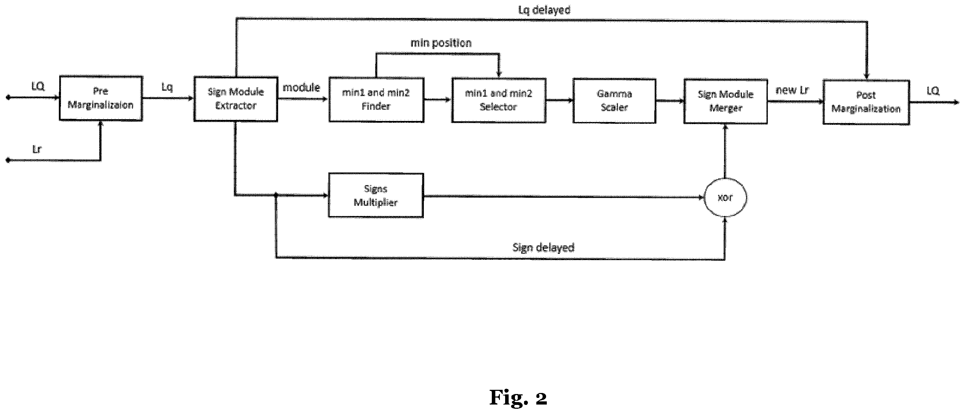

To provide the stage for the following disclosure and introduce a notation coherent with the notation used in the prior art, the "sum-product" algorithm (SPA) proposed by D. J. C. MacKay, "Good error-correcting codes based on very sparse matrices," IEEE TRANSACTIONS ON INFORMATION THEORY, vol. 45, No. 2, pp. 399-431, Mar. 1999, and its low-complexity version "normalized min sum" algorithm (NMS) is described in the following with reference to Fig. 1 and Fig. 2.

In the notation introduced by MacKay (which is based on Tanner graphs), *qᵢⱼ* denotes the message of the *i* - *th* bit node to the *j* - *th* check node and *rⱼᵢ* denotes the message of the *j* - *th* check node to the *i* - *th* bit node, wherein the number of the check nodes is equal to the number *r* of the rows of parity matrix *H,* while the number of the bit nodes is equals to the number of the columns *n* .

In the logarithmic domain, the quantities of interest may be the following probability ratios:
- Reliability information/values derived from the channel output: ${Lc}_{i} = log \frac{Pr \left({b}_{i}=0 |{s}_{i}\right)}{Pr \left({b}_{i}=1 |{s}_{i}\right)}$
- Check node value: ${Lr}_{ji} = log \frac{{r}_{ij} \left(0\right)}{{r}_{ij} \left(1\right)}$
- Bit node value: ${Lq}_{ij} = log \frac{{q}_{ij} \left(0\right)}{{q}_{ij} \left(1\right)} = sgn \left({Lq}_{ij}\right) ⋅ \left|{Lq}_{ij}\right| = {α}_{ij} ⋅ {β}_{ij}$

With *Rⱼ* = {*j: H*(*i, j*) = 1}, i.e., the set of the indexes of the columns of the parity check matrix *H* that, in the row *i*, have the value '1', and with *Cᵢ* = {*i* : *H*(*i*, *j*) =1} indicating the set of the indexes of the rows that, in the column *j*, have the value '1', the SPA algorithm may be summarized as in the followings lines:
1. ${Lq}_{ij} = {Lc}_{i} = {LLR}_{i} / {σ}_{i}^{2} , ∀ i , j : H \left(i, j\right) = 1$
2. ${Lr}_{ji} = \left({\prod }_{i ′ ∈ {R}_{j \ i}} sgn \left({Lq}_{i ′ j}\right)\right) ⋅ ϕ \left({\sum }_{j ′ ∈ {R}_{j \ i}} ϕ \left(\left|{Lq}_{i ′ j}\right|\right)\right)$
3. ${Lq}_{ij} = {Lc}_{i} + {\sum }_{j ′ ∈ {C}_{i \ j}} {Lr}_{j ′ i}$
4. ${LQ}_{i} = {Lc}_{i} + {\sum }_{j ∈ C} {Lr}_{ji}$
5. ${\hat{c}}_{i} = { \begin{matrix}1 , & {LQ}_{i} < 0 \\ 0 , & {LQ}_{i} > 0\end{matrix}$

i. if (*ĉᵢH* = 0 or iteration=MAX) → STOP
ii. else → go to step 1
with *φ* denoting $ϕ \left(x\right) = - logtanh \left(x/2\right) = log \frac{{e}^{x} + 1}{{e}^{x} - 1}$ and *ĉᵢH* = 0 being the parity check equation of the code. If a decoded word does not satisfy the parity check equation, it can be assumed that the decoded word contains errors. With
- wr as the check node degree, which is equivalent to the weight of the rows of the matrix *H,* i.e., the number of 'Is' in the rows of *H*, and
- wc as the bit node degree, which is equivalent to the weight of the columns of the matrix *H*, i.e., the number of 'Is' in the column of *H,*
the SPA requires the following memory structures:
- *LQ* of dimension 1×*n* (soft bit word);
- *Lq* of dimension *wc*×*n* (soft bit word); and
- *Lr* of dimension *r* × *wr* (soft bit word).

The soft bit words are words of *nb* bits and correspond to the likelihood messages, i.e., the probability ratios and may, for example, be up to 8 bits wide.

There may be three different types of scheduling (wherein each type of scheduling defines an order in which the messages memorized in the memories are processed): flooding, horizontal and vertical.

Flooding scheduling updates all bit nodes first and then proceeds to update the check nodes. The phases, for each iteration, are shown in the following pseudo-code that comprises two phases:
Phase 1. for every row i:
   a) updating the probability equation related to the check node (reading from the memory *Lq*) ${Lr}_{i} = {\prod }_{n ∈ {R}_{i}} sign \left({Lq}_{in}\right) \times ϕ \left({\sum }_{n ∈ {R}_{i}} ϕ \left(\left|{Lq}_{in}\right|\right)\right)$
   b) marginalization of the probability equation related to the check node (writing on memory *Lr*) $∀ j , {Lr}_{ij} = sgn \left({Lr}_{i}\right) \times sgn \left({Lq}_{ij}\right) \times ϕ ⌊ ϕ \left(\left|{Lr}_{i}\right|\right) - ϕ \left(\left|{Lq}_{ij}\right|\right) ⌋$
Phase 2. for every column j:
   a) updating the a-posteriori messages (updating the memory structure storing *LQ*) ${Lq}_{j} = {\sum }_{m ∈ {R}_{j}} {Lr}_{mj} + {Lc}_{j}$
   b) updating the probability related to the bit node (updating the memory structure storing *Lq*) $∀ m , {Lq}_{mj} = {Lq}_{j} - {Lr}_{mj}$

The above equations are equivalent to the SPA original ones, but make the implicit calculation of the extrinsic information in the previous formulation of *R_{j\i}* (*R_{j\i}* indicating the set of indexes where the message related to element that is under calculation is not considered) explicit. This is an important aspect of the used decoding algorithm and is usually called marginalization. Also important is that this way of calculating the extrinsic information requires less operations.

The complexity of the SPA can be reduced by using the following approximation: $ϕ \left({\sum }_{i ′ ∈ {R}_{j \ i}} ϕ \left(\left|{Lq}_{ji ′}\right|\right)\right) ≅ ϕ \left(ϕ\left({min}_{i ′}\left(\left|{Lq}_{ji ′}\right|\right)\right)\right) = {min}_{i ′} \left(\left|{Lq}_{ji ′}\right|\right) , with ϕ \left(ϕ\left(x\right)\right) = x$ I.e., as the result is dominated by the smallest value in the sum, the result can be approximated by calculating two absolute minimums between the modulus of the *Lq* messages. The *Lq* messages are those related to the parity equation of the row of the parity check matrix *H* that is processed. The necessity to calculate two minimums (instead of only one) comes from the fact that the information is always extrinsic. If, for example, the sequence of *Lq* messages to process is {4.0,5.1,5. 2,3.1,2.1, 3.3,1.4,6. 0,6.0}, where the absolute minimum is in the seventh position, the output sequence will be {1.4,1.4,1. 4,1.4,1.4, 1.4,2.1,1. 4,1.4 }. The value in the seventh position is now the second absolute minimum. This simplification reduces performance to an extent that can be (sometimes completely) recovered by multiplying the output sequence by a scaling factor *γ* of about 0.7.

In this regard, it is important to note that it is not needed to know the variance of the Gaussian noise related to each LLR coming from the demapper.

Another important choice is the scheduling type. Reasons for using horizontal scheduling are:
- the memory saving, since the *Lq* memory is not required;
- a faster convergence, as for a given performance, the iterations are halved; and
- that it is suitable for a parallel architecture.

In this case, the decoding procedure has only one phase which combines the two phases (Phase 1 and Phase 2) for calculating the values *Lq.* As described by M. Mansour and N. Shambhag, "Memory-efficient turbo decoder architectures for LDPC codes", IEEE WORKSHOP ON SIGNAL PROCESSING SYSTEMS, pp. 159-164, Oct.2002, the "two phase message passing" (TPMP) can be replaced by "turbo decoding message passing" (TDMP). In brief, the TDMP is characterized by:
a) the node bit phase is comprised in the check node phase: ${Lr}_{ji} = \left[{\prod }_{i ′} sgn \left({LQ}_{ji ′}-{Lr}_{ji ′}\right)\right] \times \left[{min}_{i ′}\left(\left|{LQ}_{ji ′}-{Lr}_{ji ′}\right|\right)\right]$
b) during the processing of the current check-node all the connected bit-nodes are updated; and
c) the propagation of "always up-to-date" messages speeds up the convergence factor by two.

For example, looking at the matrix in Fig. 1, the processing of the third parity equation (*cn* 2) requires four bit-node messages where 3 of the 4 has been already updated in the processing of the two previous equations (i.e., *q*0 and *q*7 in the updating of row 1, *q*6 in the updating of row 2). With *Iᵢ* denoting the subset of the column index *Rᵢ*, the pseudo-code then becomes:

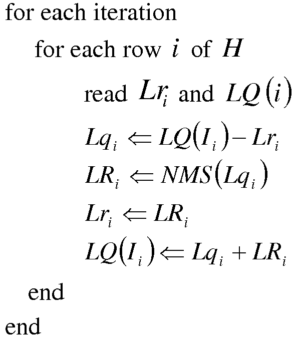

The terms *LQ* and *Lr* are vectors that are read from the memory structures *LQ* and *Lr.* If, for example, the weight of the *i* - *th* row is 22, *LQ* and *Lr* each comprises 22 elements (wherein each element is 8 bits wide), *LQ*(*Iᵢ*) indicates that 22 (not adjacent) values have to be selected from the memory *LQ* based on *Iᵢ* as index (or address), which can be derived from row *i* of the parity check matrix *H.* With these 22 values, the *Lq* values are calculated which, after being processed by a NMS function, give the new values to update the memory *Lr.* Adding the previously obtained *Lq* to these *Lr,* the locations of *LQ* indicated by *Iᵢ* can be updated. The function that calculates the *Lr = NMS* (*Lq*) is ${Lr}_{ij} = γ ⋅ {\prod }_{n ∈ {R}_{i \ j}} sgn \left({Lq}_{in}\right) \times {min}_{n ∈ {R}_{i \ j}} \left(\left|{Lq}_{in}\right|\right) .$

For efficiency reason, and for the architecture chosen, the multiplication of all the signs may be calculated and finally multiplied to extract the extrinsic information (marginalization). This is the analogy to the calculus of the extrinsic information using two minimums. At the end, the modulus is scaled by the factor gamma (*γ*). To give an overview, the functional blocks of a calculus or "decoding unit" (DU) for TDMP based on the NMS algorithm are depicted in Fig. 2.

Fig. 3 shows a block diagram of a digital communication system in which the decoding procedure of the present invention may be implemented (e.g., at the decoder CH_DEC of the system). As shown in Fig. 3, a binary word A1 (information sequence) of *kᵢ* bits may be encoded by a channel encoder CH_ENC that adds *r* = *n_{c}* - *kᵢ* parity bits (redundancy sequence) to the information sequence to obtain a binary word A2 (encoded sequence) of *n_{c}* bits. The channel code-rate *R* is defined as the ratio between the number of information bits *kᵢ* and the number of encoded bits *n_{c}*, thus *R* = *kᵢ*/*n_{c}*.

The modulator MOD may transform the encoded vector A2 into a modulated signal vector CH_IN which is in turn transmitted through a channel CH which may, for example, correspond to a wired and/or wireless transmission path. The encoder CH_ENC and the modulator MOD may be comprised in an electronic device that performs the encoding/modulation procedure using customized hardware and/or a processor executing instructions stored in a machine-readable medium. Since the channel CH is usually subject to noisy disturbance NS, the channel output CH_OUT may differ from the channel input CH_IN.

On the receiver side, the channel output CH_OUT may be processed by the demodulator DEM which may perform the MOD inverse operation (demodulation) and produce some likelihood ratio (soft bits). The channel decoder CH_DEC may use the redundancy in the received sequence A3 to correct errors in the information part of the received sequence A3 and produce a decoded signal A4 which is an information sequence estimate.

The encoder/decoder CH_ENC, CH_DEC may perform the encoding/decoding procedure based on a convolutional code with a LDPC matrix as proposed by A. J. Felstrom and K. Zigangirov (see above). As a consequence, the *n_{c}* encoded bits output by the encoder CH_ENC depend not only on the *kᵢ* input bits received at the current iteration, but also on *M* previous input blocks (of *kᵢ* input bits each).

The transposed parity-check matrix, called syndrome matrix, of a periodical binary convolutional code with memory M, code-rate *R* = *kᵢ*/*n_{c}*, code-period *T* = *M* - 1 and code-period number *p* is: ${H}^{T} = \left[\begin{matrix}{H}_{0}^{\left(0\right)} & {H}_{1}^{\left(1\right)} & {H}_{2}^{\left(2\right)} & {H}_{3}^{\left(3\right)} & . & {H}_{M}^{\left(M\right)} & 0 & 0 & 0 & 0 & . & 0 \\ 0 & {H}_{1}^{\left(0\right)} & {H}_{2}^{\left(1\right)} & {H}_{3}^{\left(2\right)} & . & {H}_{M}^{\left(M-1\right)} & {H}_{M + 1}^{\left(M\right)} & 0 & 0 & 0 & . & 0 \\ 0 & 0 & {H}_{2}^{\left(0\right)} & {H}_{3}^{\left(1\right)} & . & {H}_{M}^{\left(M-2\right)} & {H}_{M + 1}^{\left(M-1\right)} & {H}_{M + 2}^{\left(M\right)} & 0 & 0 & . & 0 \\ 0 & 0 & 0 & {H}_{3}^{\left(0\right)} & . & {H}_{M}^{\left(M-3\right)} & {H}_{M + 1}^{\left(m-2\right)} & {H}_{M + 2}^{\left(M-1\right)} & {H}_{M + 3}^{\left(M\right)} & 0 & . & 0 \\ . & . & . & . & . & . & . & . & . & . & . & . \\ 0 & 0 & 0 & 0 & . & 0 & {H}_{\left[\left(M-1\right)⋅p-1\right]}^{\left(0\right)} & {H}_{\left[\left(M-1\right)⋅p\right]}^{\left(1\right)} & {H}_{\left[\left(M-1\right)⋅p+1\right]}^{\left(2\right)} & . & . & {H}_{\left[M+2⋅T-1\right]}^{\left(M\right)}\end{matrix}\right]$ where each element ${H}_{t}^{\left(m\right)}$ with *m* = 0,1,2,..., *M* and *t* = 0,1,2,... is a binary sub-matrix of the size *n_{c}* × (*n_{c}* - *kᵢ*).

For example, for a code-rate *R* = *kᵢ* / *n_{c}* = 2/3, a code-period *T* = *M* -1 = 7 - 1 = 6 and a code-period number *p* = 2 , each element of the transposed parity-check matrix ${H}_{t}^{\left(m\right)}$ is a parity matrix of size *n_{c}* × (*n_{c}* - *kᵢ*) = 3 × 1. Then, the syndrome matrix *H^{T}* of equation (4) becomes: ${H}^{T} = \left[\begin{matrix}{h}_{1}^{\left(0\right)} \left(0\right) & {h}_{1}^{\left(1\right)} \left(1\right) & {h}_{1}^{\left(2\right)} \left(2\right) & . & {h}_{1}^{\left(7\right)} \left(7\right) & 0 & 0 & . & 0 & 0 & . & 0 \\ {h}_{2}^{\left(0\right)} \left(0\right) & {h}_{2}^{\left(1\right)} \left(1\right) & {h}_{2}^{\left(2\right)} \left(2\right) & . & {h}_{2}^{\left(7\right)} \left(7\right) & 0 & 0 & . & 0 & 0 & . & 0 \\ {h}_{3}^{\left(0\right)} \left(0\right) & {h}_{3}^{\left(1\right)} \left(1\right) & {h}_{3}^{\left(2\right)} \left(2\right) & . & {h}_{3}^{\left(7\right)} \left(7\right) & 0 & 0 & . & 0 & 0 & . & 0 \\ 0 & {h}_{1}^{\left(0\right)} \left(1\right) & {h}_{1}^{\left(1\right)} \left(2\right) & . & {h}_{1}^{\left(6\right)} \left(7\right) & {h}_{1}^{\left(7\right)} \left(8\right) & 0 & . & 0 & 0 & . & 0 \\ 0 & {h}_{2}^{\left(0\right)} \left(1\right) & {h}_{2}^{\left(1\right)} \left(2\right) & . & {h}_{2}^{\left(6\right)} \left(7\right) & {h}_{2}^{\left(7\right)} \left(8\right) & 0 & . & 0 & 0 & . & 0 \\ 0 & {h}_{3}^{\left(0\right)} \left(1\right) & {h}_{3}^{\left(1\right)} \left(2\right) & . & {h}_{3}^{\left(6\right)} \left(7\right) & {h}_{3}^{\left(7\right)} \left(8\right) & 0 & . & 0 & 0 & . & 0 \\ 0 & 0 & {h}_{1}^{\left(0\right)} \left(2\right) & . & {h}_{1}^{\left(5\right)} \left(7\right) & {h}_{1}^{\left(6\right)} \left(8\right) & {h}_{1}^{\left(7\right)} \left(9\right) & . & 0 & 0 & . & 0 \\ 0 & 0 & {h}_{2}^{\left(0\right)} \left(2\right) & . & {h}_{2}^{\left(5\right)} \left(7\right) & {h}_{2}^{\left(6\right)} \left(8\right) & {h}_{2}^{\left(7\right)} \left(9\right) & . & 0 & 0 & . & 0 \\ 0 & 0 & {h}_{3}^{\left(0\right)} \left(2\right) & . & {h}_{3}^{\left(5\right)} \left(7\right) & {h}_{3}^{\left(6\right)} \left(8\right) & {h}_{3}^{\left(7\right)} \left(9\right) & . & 0 & 0 & . & 0 \\ . & . & . & . & . & . & . & . & . & . & . & . \\ . & . & . & . & . & . & . & . & . & . & . & . \\ . & . & . & . & . & . & . & . & . & . & . & . \\ 0 & 0 & 0 & . & 0 & 0 & 0 & . & {h}_{1}^{\left(0\right)} \left(11\right) & {h}_{1}^{\left(1\right)} \left(12\right) & . & {h}_{1}^{\left(7\right)} \left(18\right) \\ 0 & 0 & 0 & . & 0 & 0 & 0 & . & {h}_{2}^{\left(0\right)} \left(11\right) & {h}_{2}^{\left(1\right)} \left(12\right) & . & {h}_{2}^{\left(7\right)} \left(18\right) \\ 0 & 0 & 0 & . & 0 & 0 & 0 & . & {h}_{3}^{\left(0\right)} \left(11\right) & {h}_{3}^{\left(1\right)} \left(12\right) & . & {h}_{3}^{\left(7\right)} \left(18\right)\end{matrix}\right]$

The low-density parity-check matrix may be characterized by the following parameters:
- *M* determines the code period *T* = *M* -1;
- *Ju* is the row weight (number of elements equal to '1' in the subrow) corresponding to the information sequence;
- *Jv* is the row weight (number of elements equal to '1' in the subrow) corresponding to the parity bits; and
- *K* is the column weight (number of elements equal to '1' in the column) starting from column [*M* · (*n_{c}* - *kᵢ*) + 1] - *th.*

The information sequence *u*_{[0,*n*]} and the encoded sequence *v*_{[0,*n*]} can be expressed by equation (6) and equation (7) as: ${u}_{\left[0, n\right]} = \left[{u}_{01},{u}_{02},{u}_{11},{u}_{12},{u}_{21},{u}_{22},{u}_{31},{u}_{32},…,{u}_{n 1},{u}_{n 2}\right]$ ${v}_{\left[0, n\right]} = \left[{v}_{01},{v}_{02},{v}_{11},{v}_{12},{v}_{21},{v}_{22},{v}_{31},{v}_{32},…,{v}_{n 1},{v}_{n 2}\right]$

The received sequence will be correct, if equation (8) is satisfied: ${\hat{v}}_{\left[0, n\right]} ⋅ {H}^{T} = 0$

For all information bits to be protected by corresponding parity bits, it is necessary to impose the following condition: $[ \begin{matrix}{h}_{1}^{\left(0\right)} \left(n\right) = 1 \\ {h}_{2}^{\left(0\right)} \left(n\right) = 1 \\ {h}_{3}^{\left(0\right)} \left(n\right) = 1\end{matrix}$ where *n* = 0,1,2,...

A systematic LDPC-CC encoder may carry-out a procedure corresponding to the following equations: ${ \begin{matrix}{v}_{n 1} = {u}_{n 1} , {v}_{n 2} = {u}_{n 2} \\ {v}_{n 3} = {\sum }_{i = 0}^{M} {h}_{1}^{\left(i\right)} \left(n\right) ⋅ {u}_{\left(n-i\right) 1} + {\sum }_{i = 0}^{M} {h}_{2}^{\left(i\right)} \left(n\right) ⋅ {u}_{\left(n-i\right) 2} + {\sum }_{i = 1}^{M} {h}_{3}^{\left(i\right)} \left(n\right) ⋅ {u}_{\left(n-i\right) 3}\end{matrix}$

As shown by T. Kishigami, Y. Murakami, and I. Yoshii, "LDPC Convolutional Codes for IEEE 802.16m FEC Scheme", IEEE 802.16 Broadband Wireless Access Working Group, LDPC-CCs have advantages in terms of encoder complexity and decoder latency as compared to conventional FEC classes such as Convolutional Turbo Codes (CTC) and LDPC Block Codes (LDPC-BC).

A binary parity-check matrix built as suggested by A. J. Felstrom and K. Zigangirov (see above) for code-rates *R*₁ = *k*_{*i*1}/*n*_{*c*1}, code-period *T* = *5,* and code-period number *p* = *3* , may be composed of three code periods, wherein the first two code periods are complete and the last code period is incomplete. The first code period and the second code period can be repeated several times (to allow for variable code-word lengths) due to which the parity-check matrix may be called semi-infinite.

In order to improve the LDPC-CC, it can be feasible to apply a "tail-biting" operation that masks the parity-check matrix columns with lower weight which correspond to the last code period. In this last code period, information bits are encoded equal to '0' (which are not transmitted), to generate the corresponding parity bits, which are transmitted.

The binary parity-check matrix construction for LDPC-CC as suggested by A. J. Felstrom and K. Zigangirov (see above):
- has no column weight equal to '1'; and
- the row layered decoding, already used in LDPC-BC, cannot be used.

Thus:
- a serial layered decoding, which decodes the same information sequence, achieves good performance (fast convergence of the belief propagation algorithm) but leads to high latency;
- a parallel layered decoding, which decodes the same information sequence, leads to weak performance (slow convergence of the belief propagation algorithm) but achieves low latency; and
- a parallel layered decoding, which decodes a different information sequence, achieves good performance (fast convergence of the belief propagation algorithm) but leads to high latency.

Besides, the binary parity-check matrix construction for LDPC-CC as suggested by A. J. Felstrom and K. Zigangirov (see above) may suffer from cycles of length 4 which lead to performance degradation of the LDPC-CC. The proposed encoding/decoding procedure for LDPC-CTC codes overcomes the aforesaid drawbacks as it constructs the seed matrix for LDPC-CTC by interlacing (two or more) binary parity-check matrixes of LDPC-CCs, wherein each LDPC-CC may be based on the construction procedure proposed by A. J. Felstrom and K. Zigangirov (see above), with (or without) concatenated parity part.

A seed matrix for a specific rate *R* masked with a full exponent matrix *E*ₑₓₚ for the rate *R* and expanded with a spreading matrix (cyclic permutation matrix) may produce the binary parity-check matrix *Hᵣₓₙ* for the LDPC-CTC which leads to significant performance gains and allows carrying-out parallel layered decoding with good performance (fast convergence of the BPA) and low decoding latency. For example, the seed matrix may be of the form:

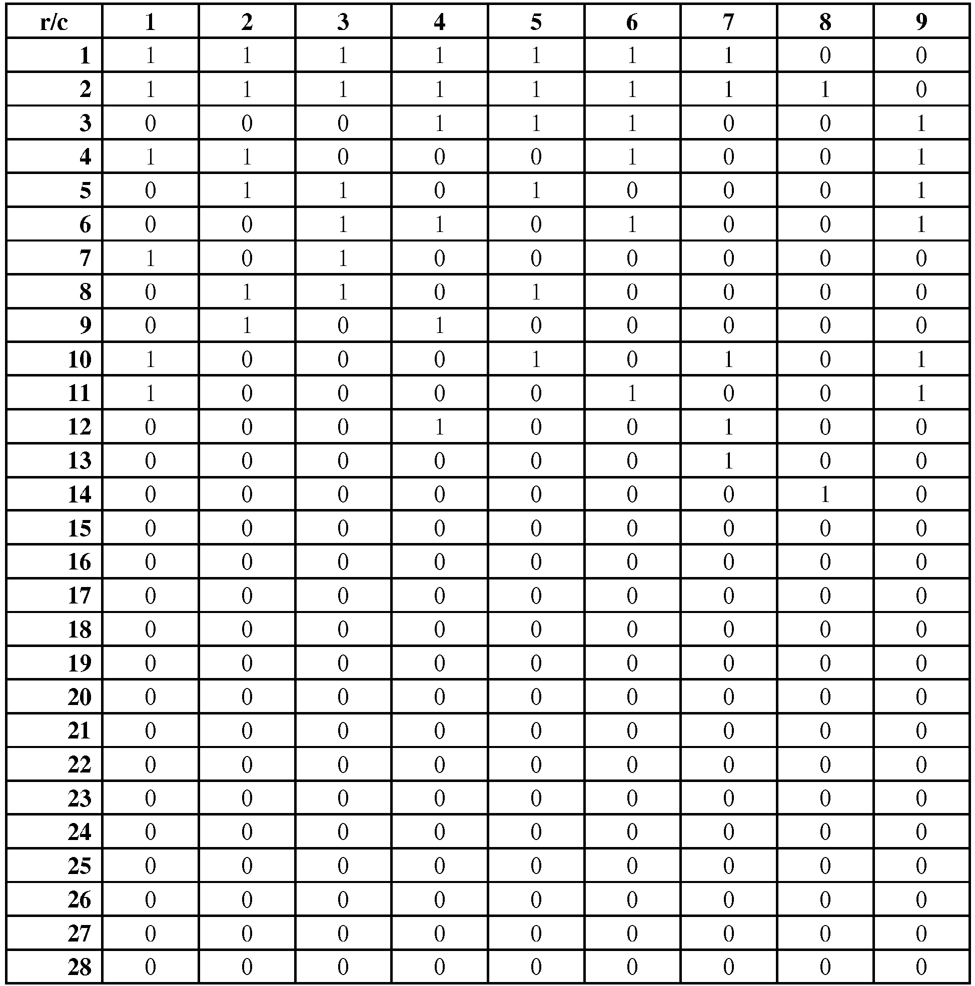

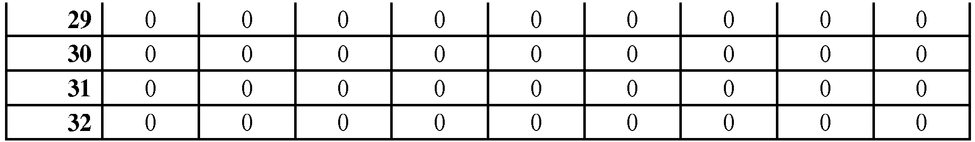

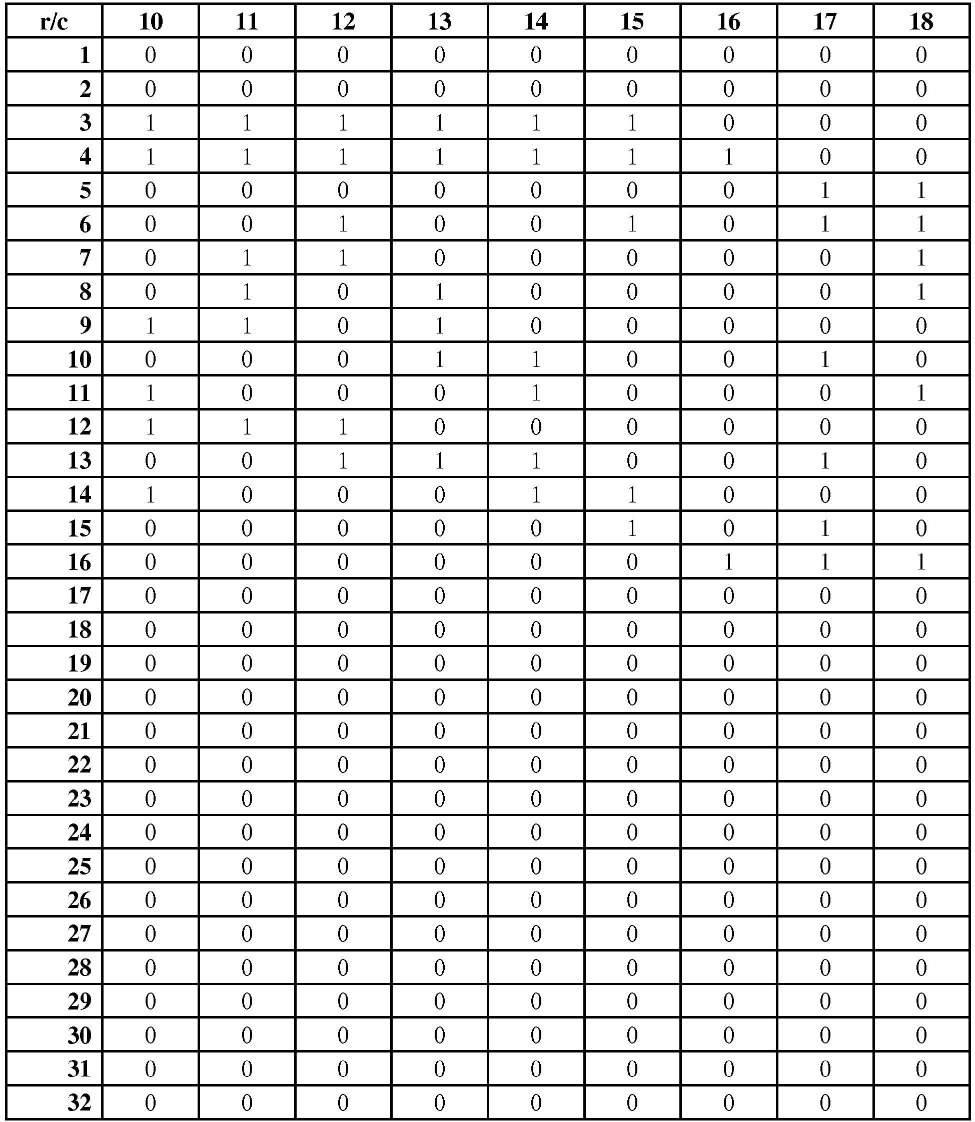

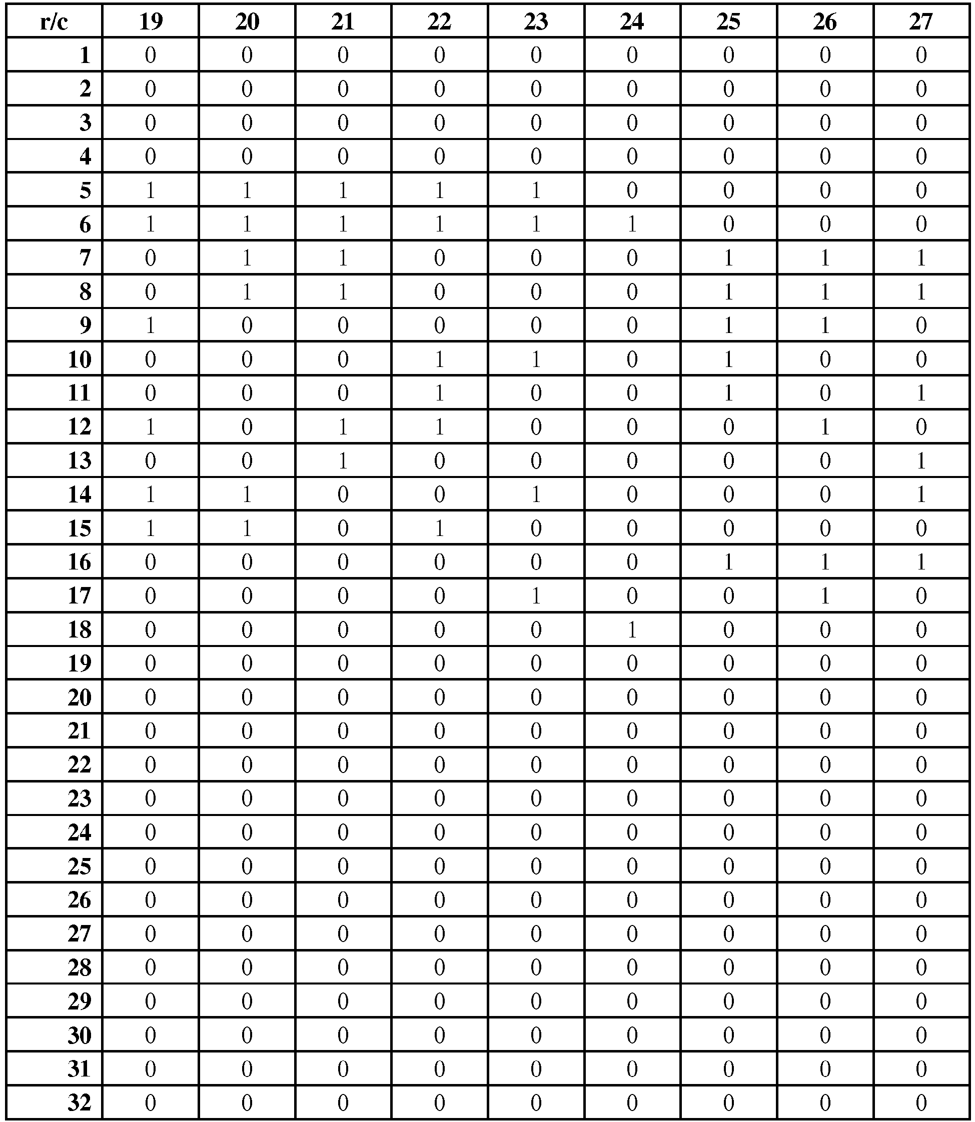

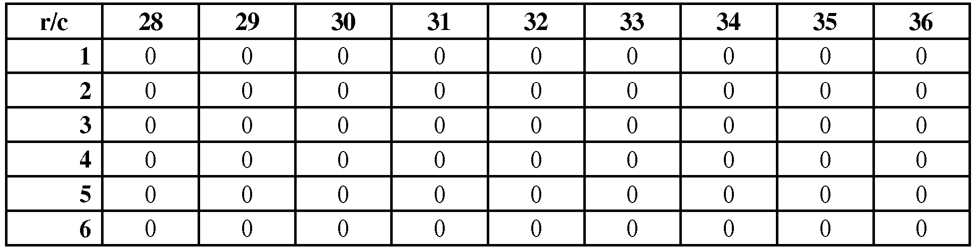

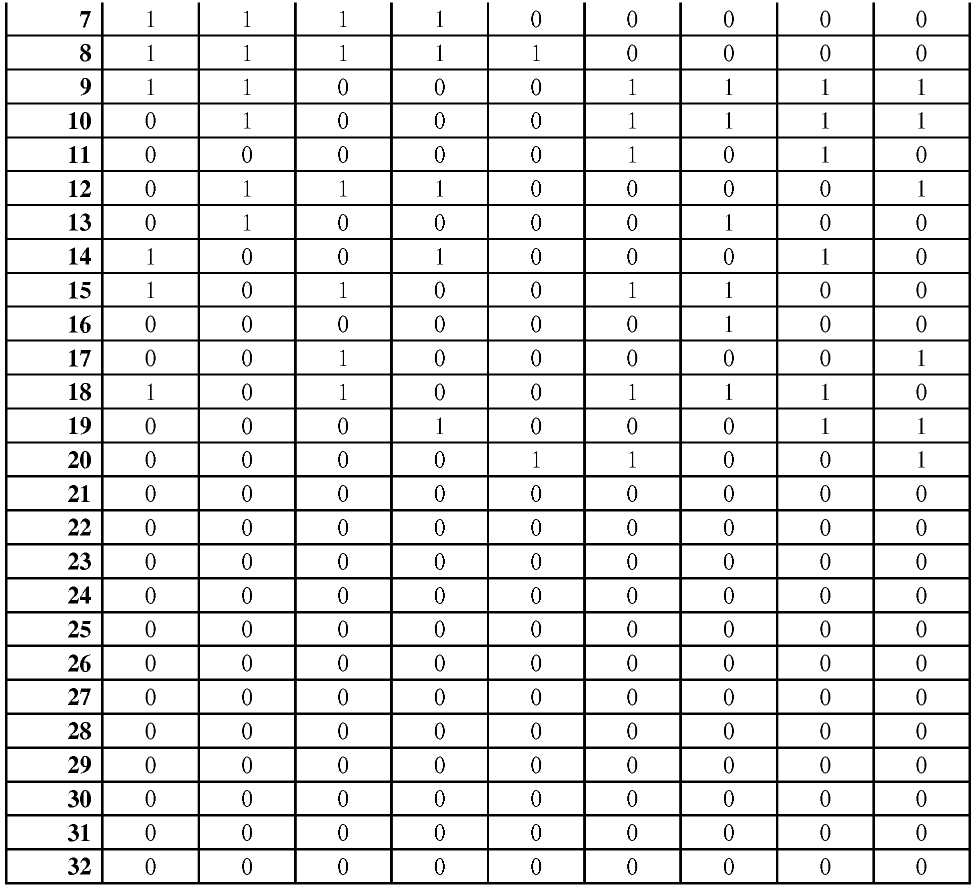

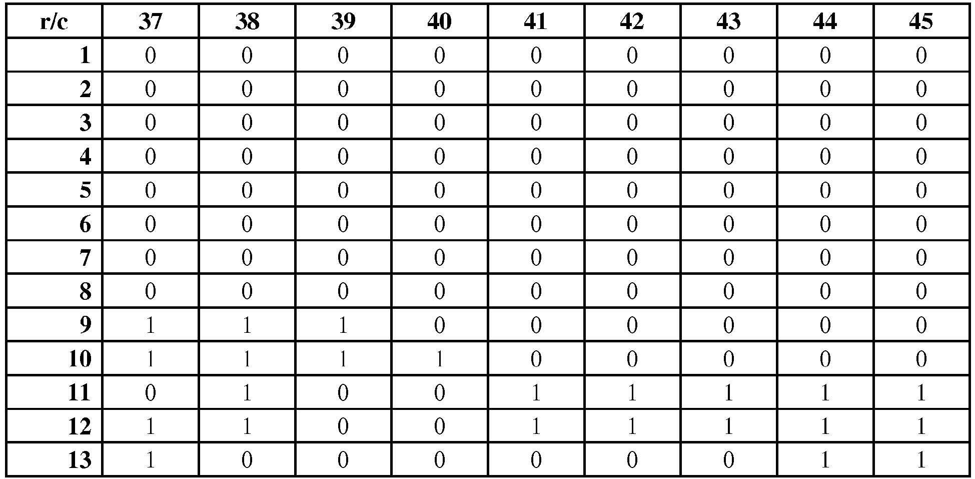

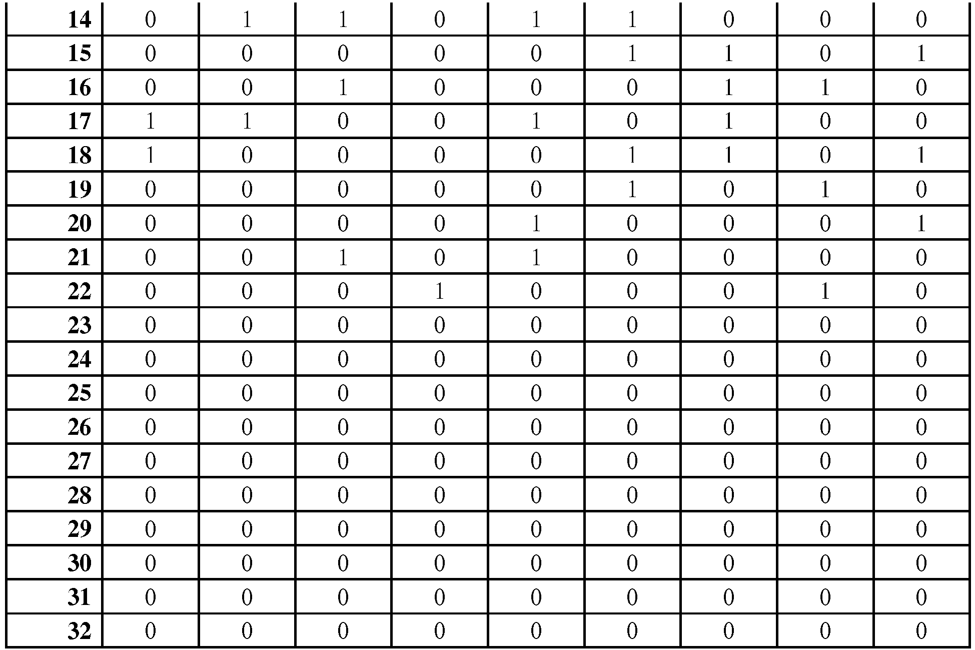

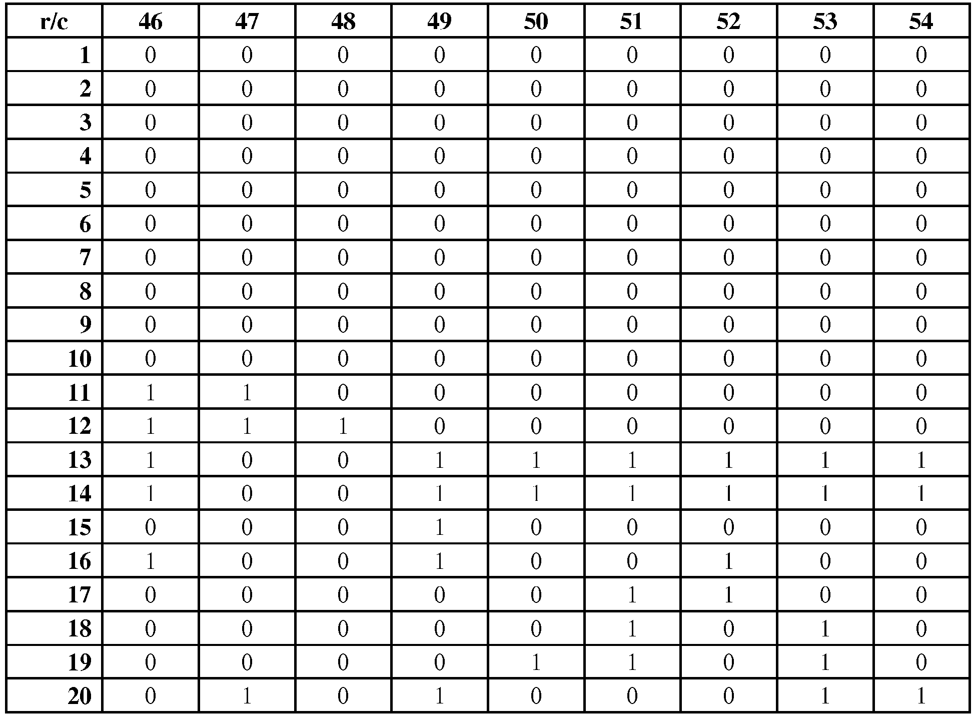

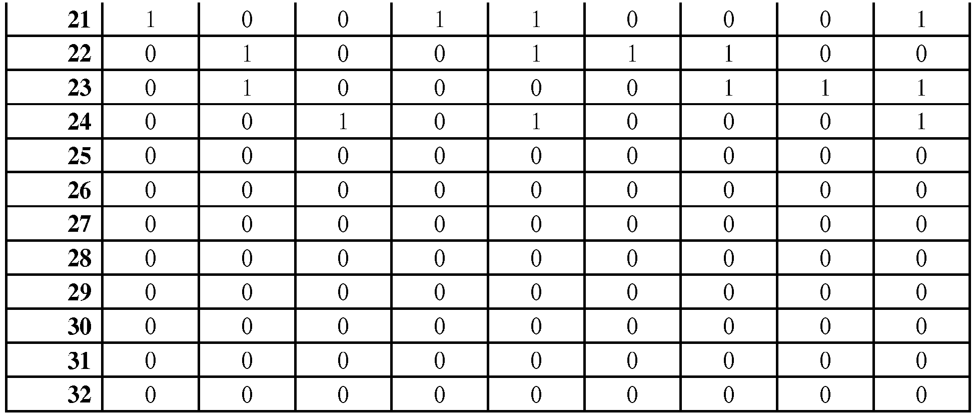

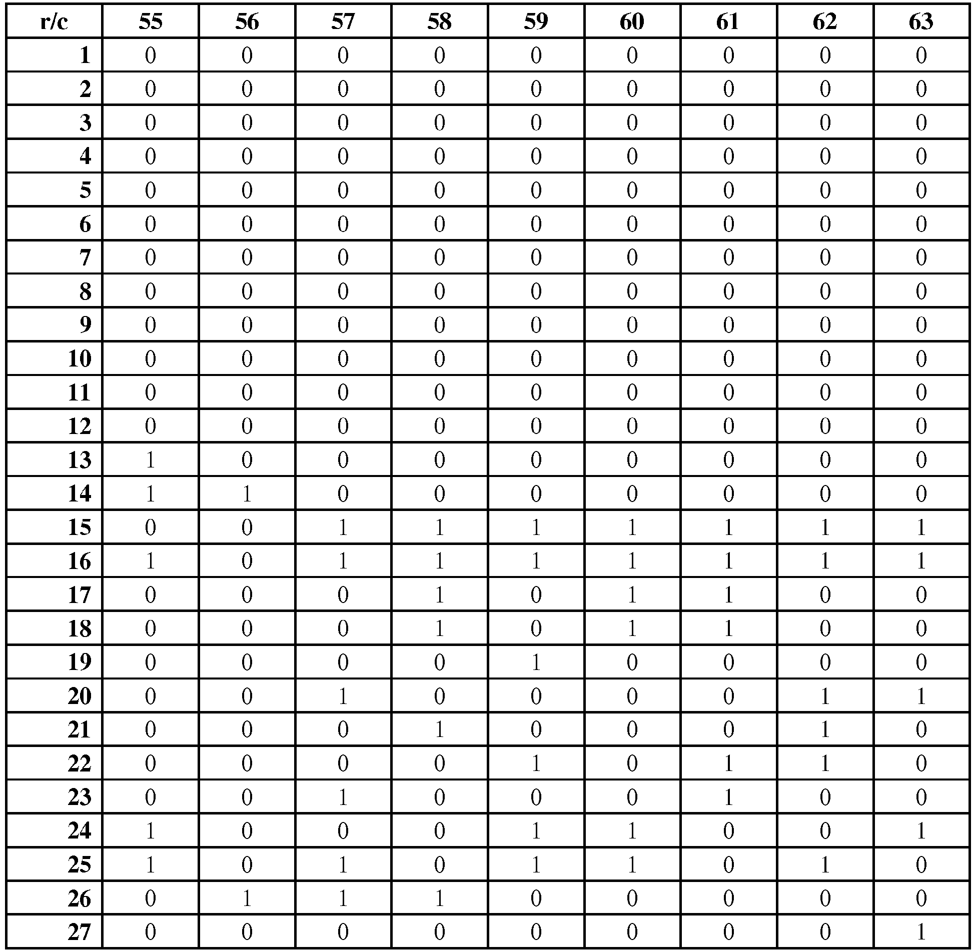

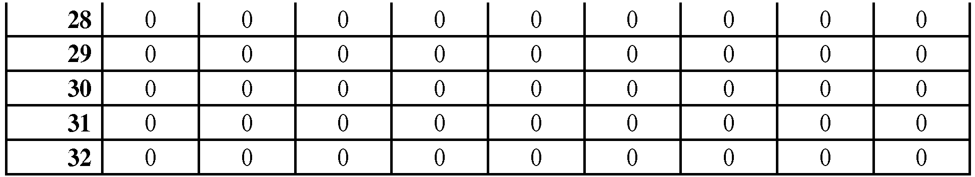

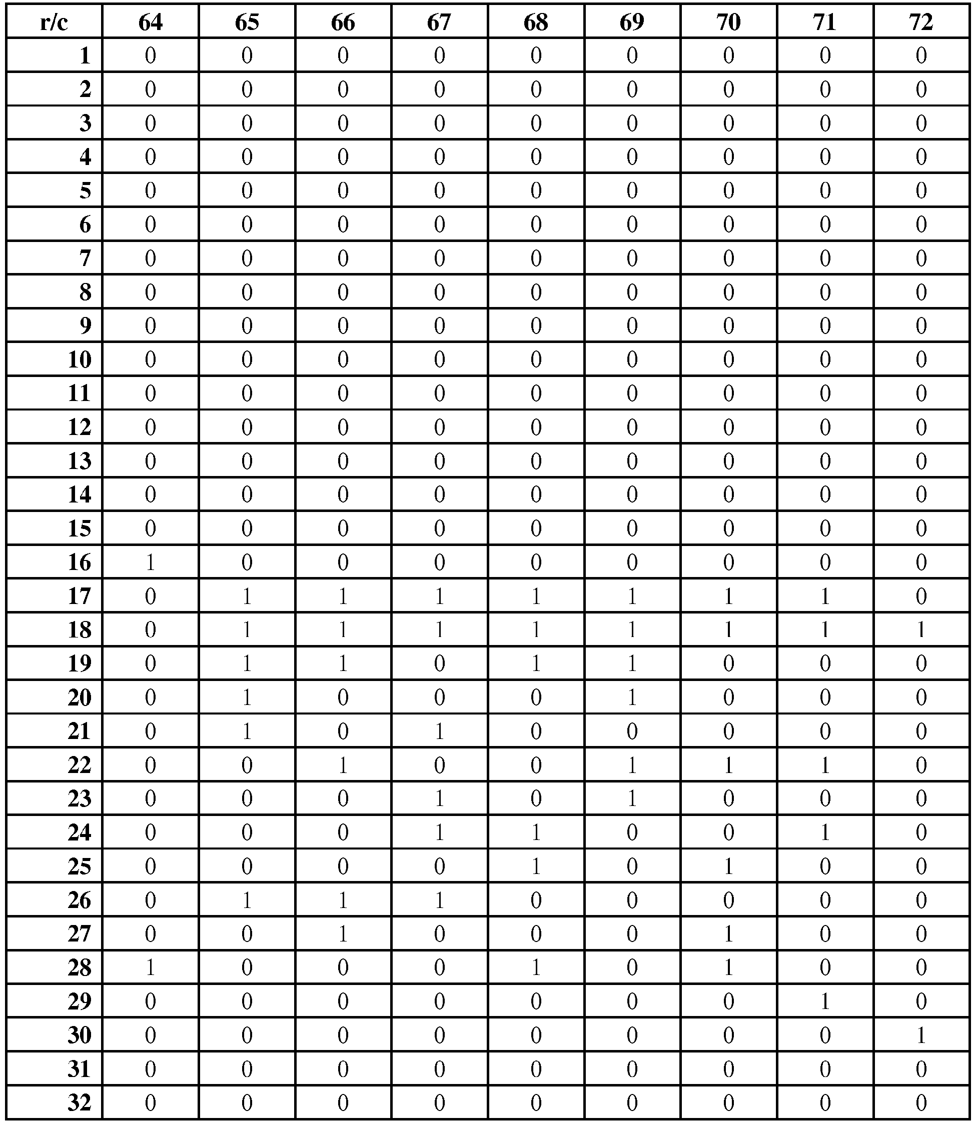

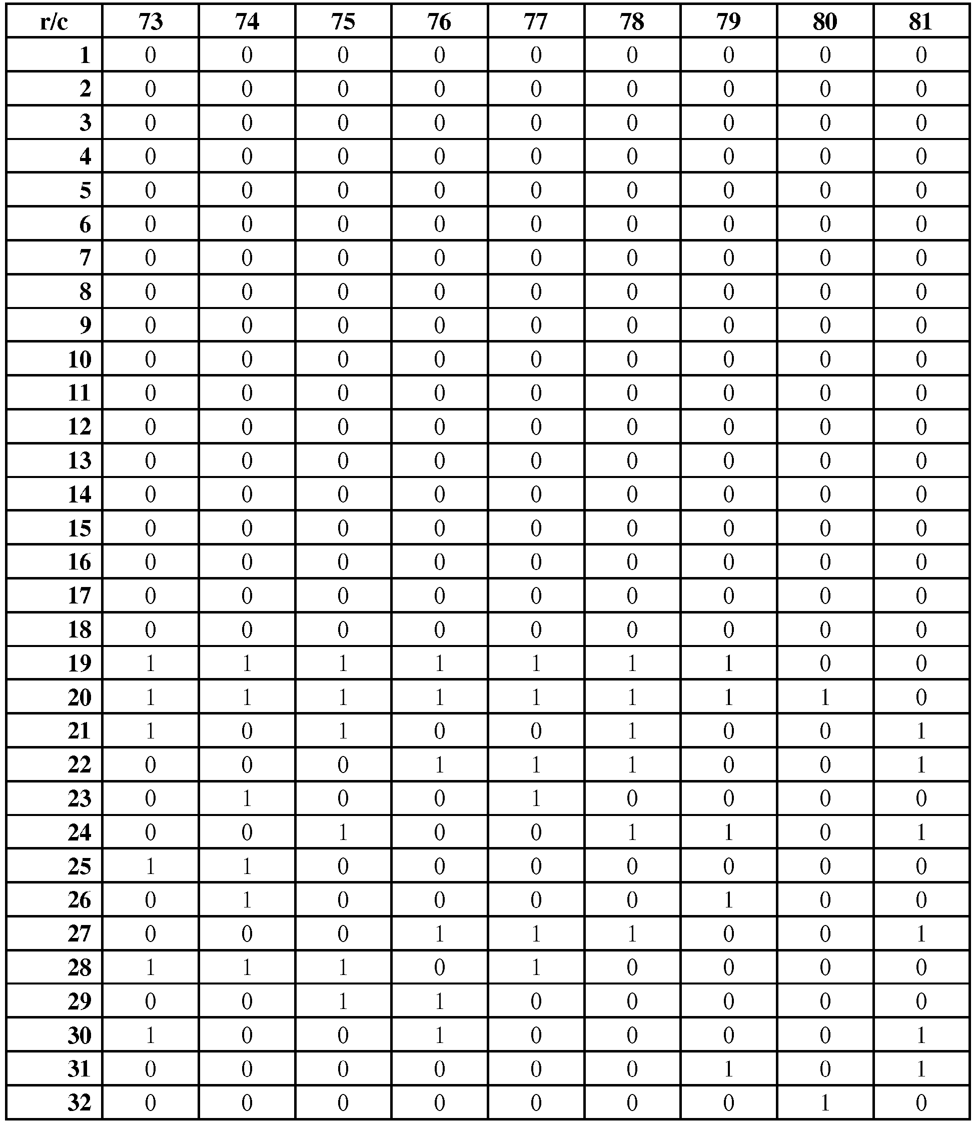

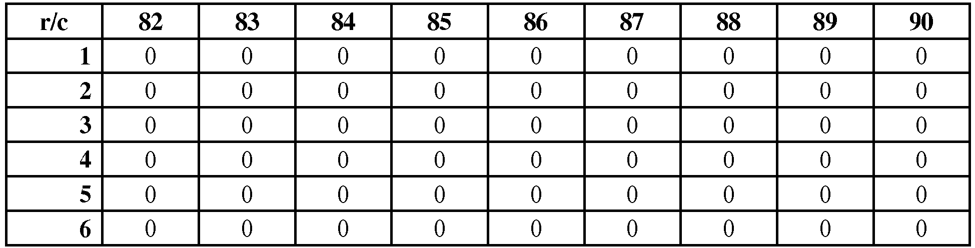

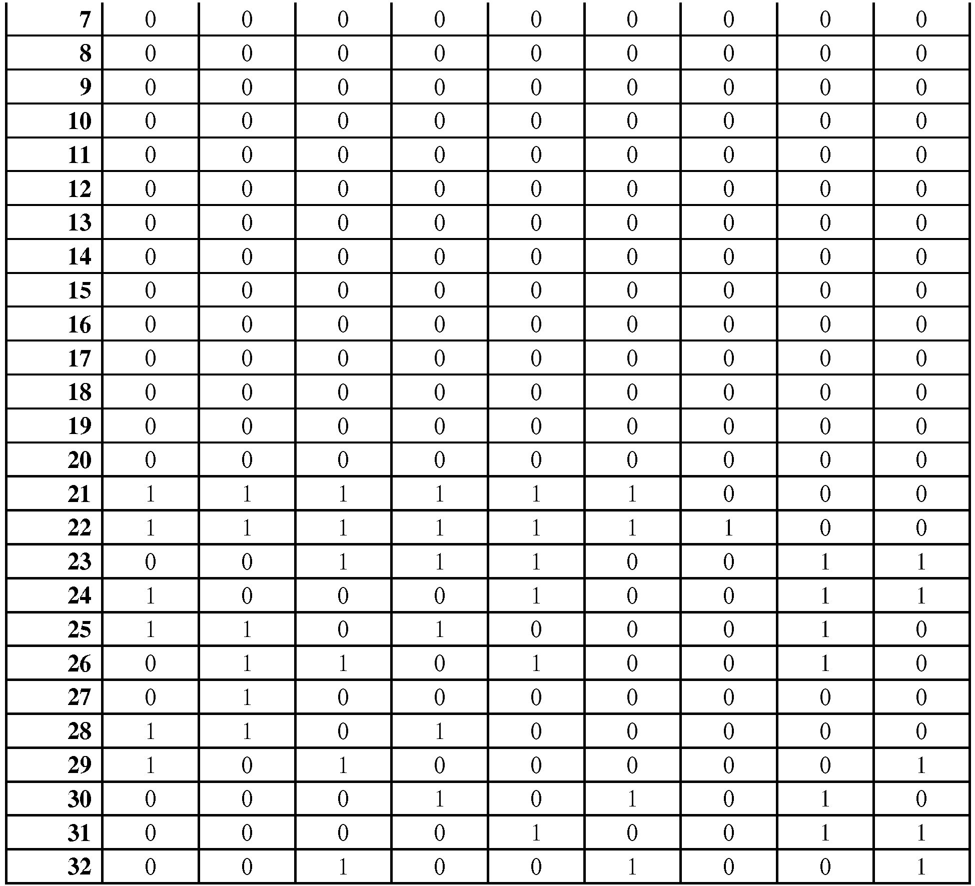

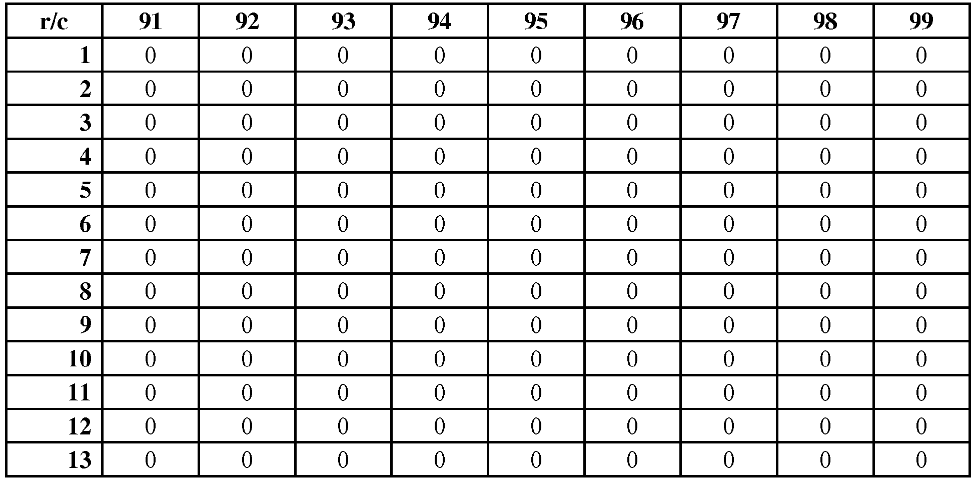

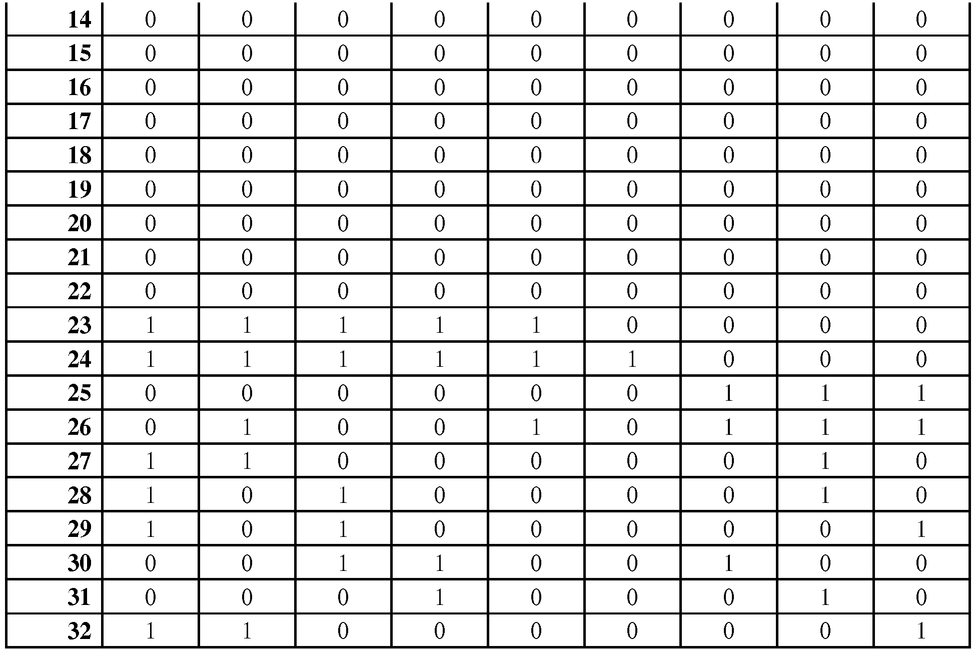

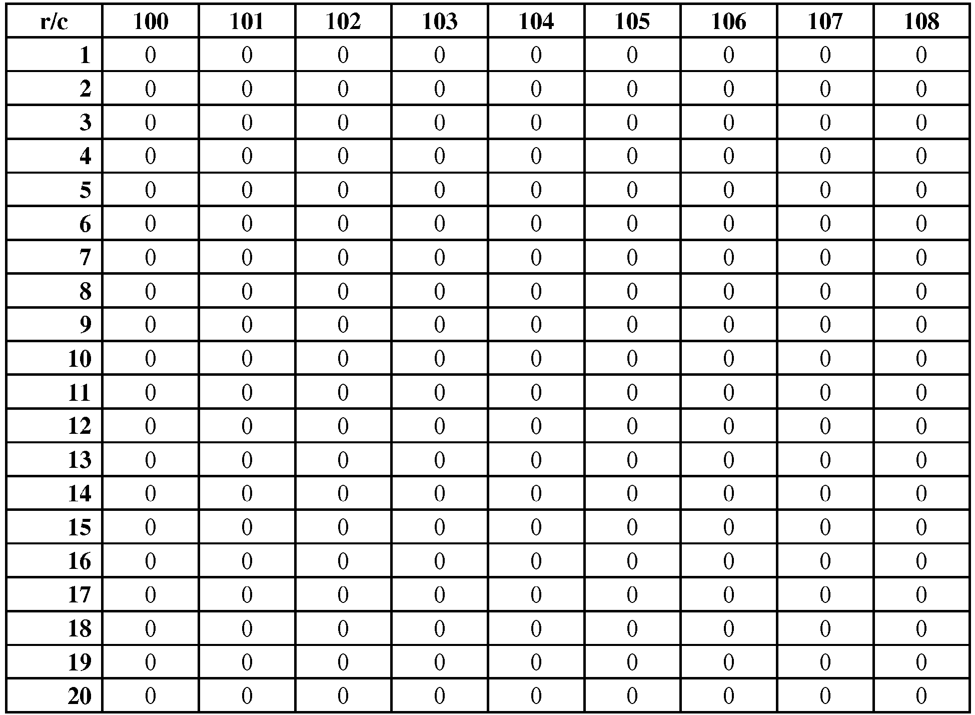

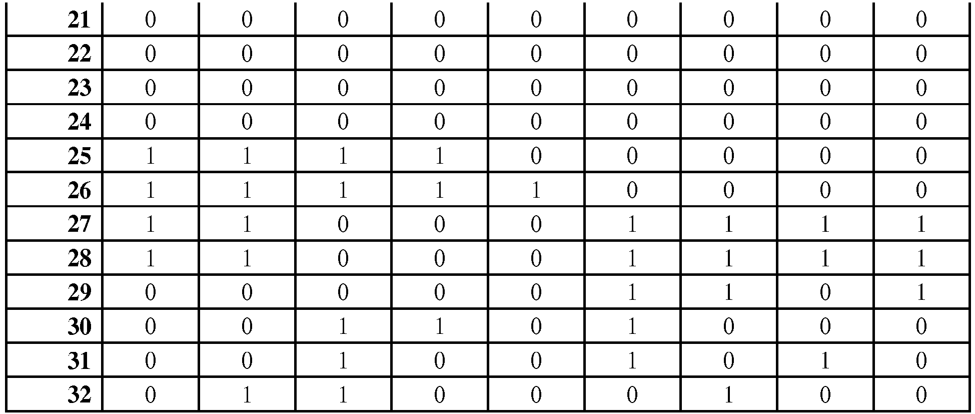

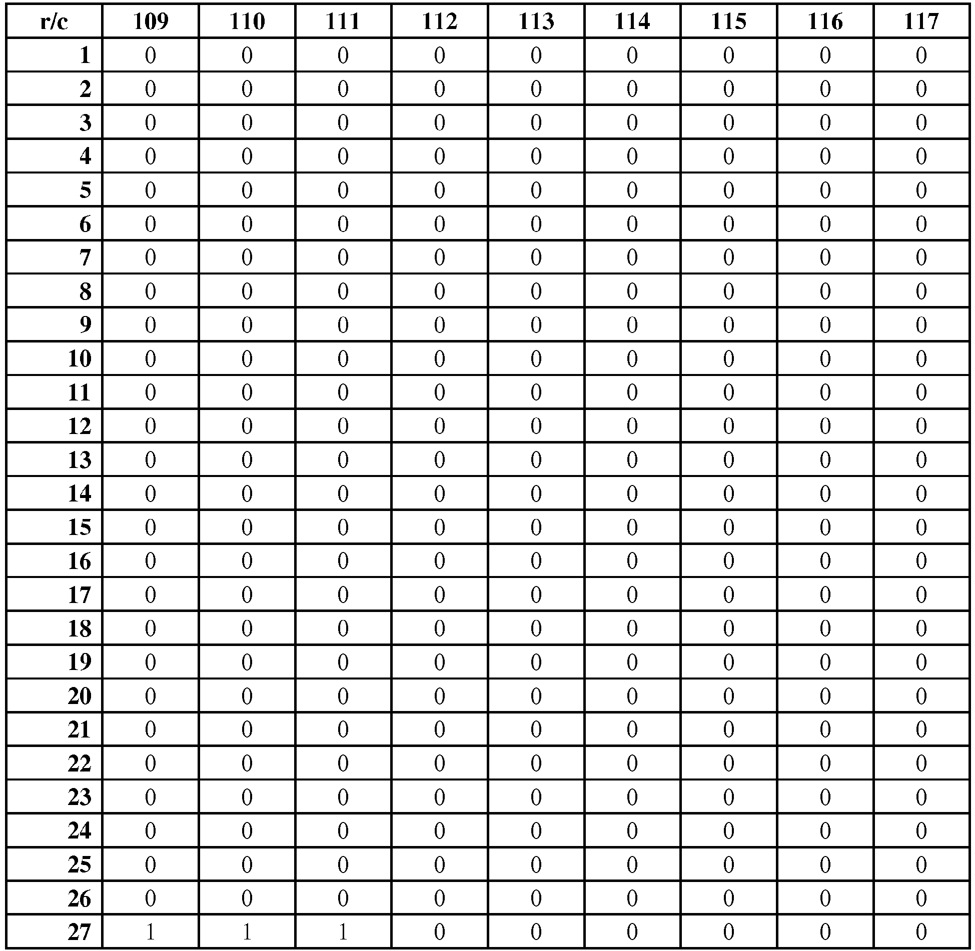

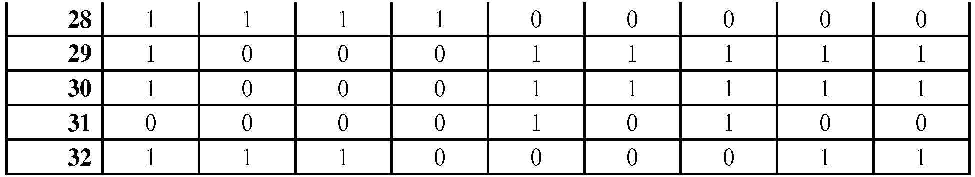

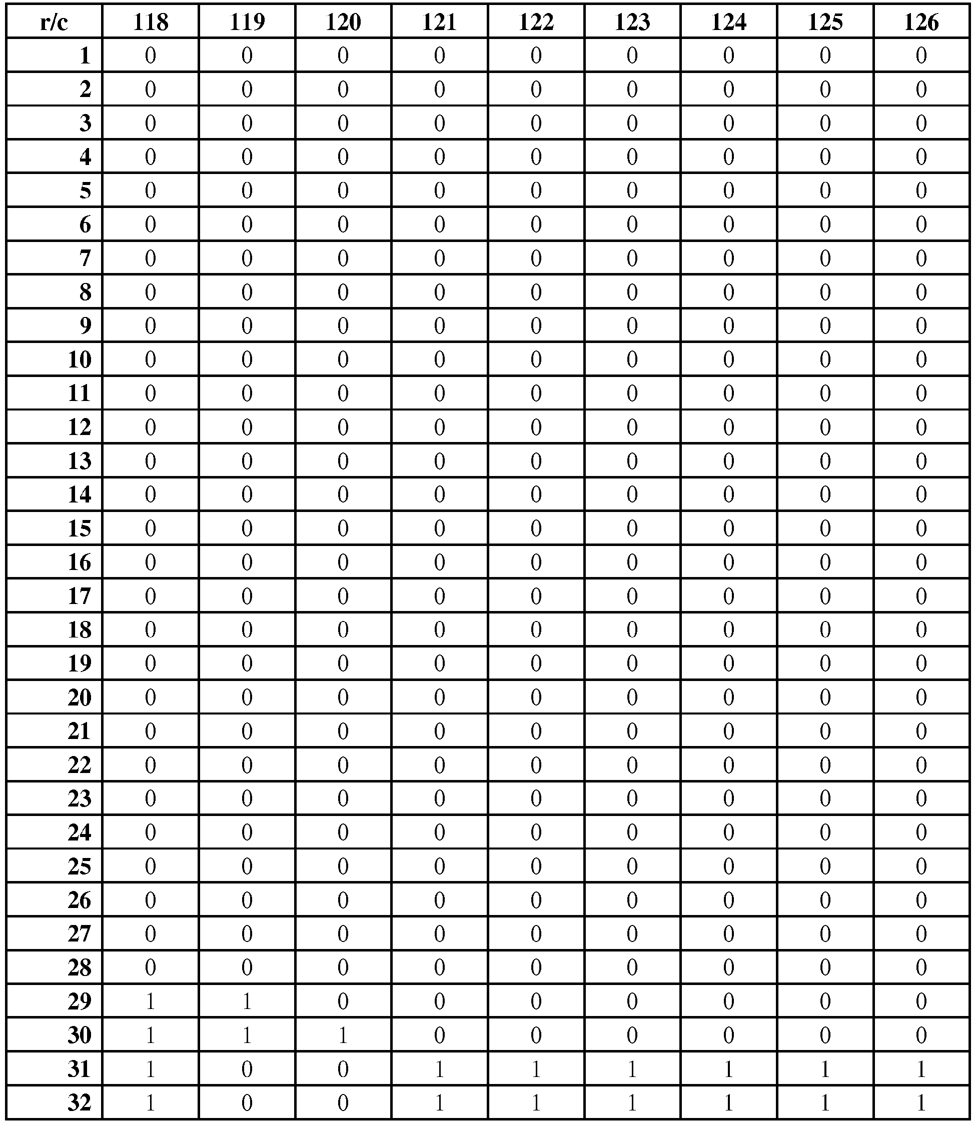

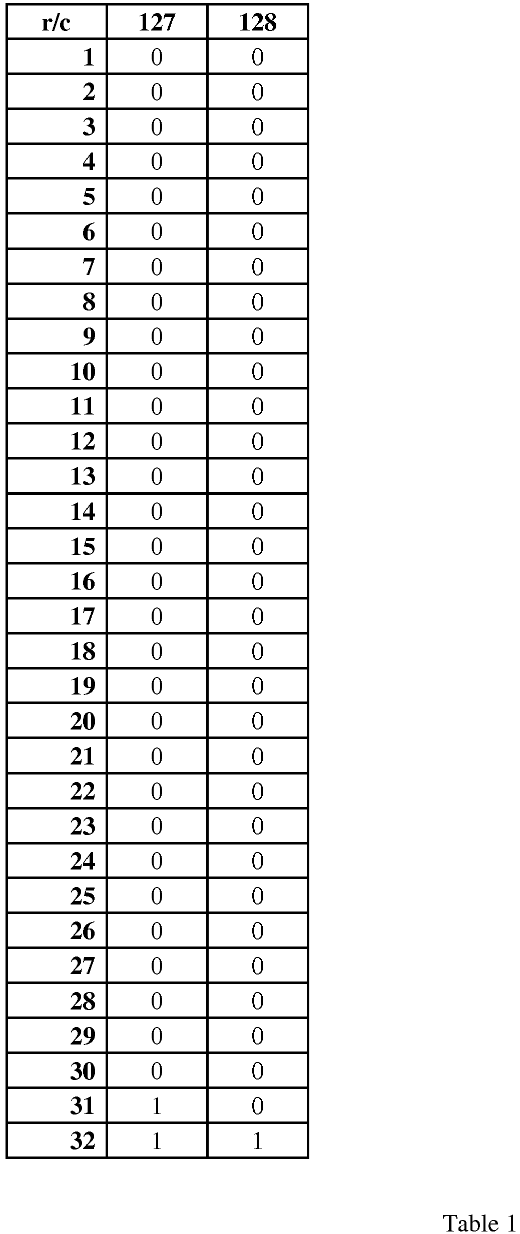

In this regard, it is noted that the LDPC-CTC does not require an interleaver circuit, because this operation can be performed by spreading matrixes with different exponent value for each parallel path (two or more). Moreover, there exists a tradeoff between the desired performance and the number of parallel concatenated LDPC-CCs (hardware complexity).

The spreading matrix is a square binary matrix (circulant permutation matrix) of weight equal to '1' and size *Z_{ƒ}xZ_{ƒ}* being *Z_{ƒ}* the spreading factor which is tied to the code-word length of the carried-out LDPC code. For example, if the spreading factor is *Z_{ƒ}* = 48 then the full exponent matrix *E*ₑₓₚ will have elements (exponents) between *0* and (*Z_{ƒ}* -1) = 47.

The exponent matrix elements with values between 0 and (*Z_{ƒ}*-1) may thus represent cyclic permutation matrixes of the identity matrix (with weight equal to '1' for each row and for each column) with size *Z_{ƒ}xZ_{ƒ}.* The value of the exponent matrix element may indicate the cyclic shift to the right of the identity matrix, as shown in the matrixes ${I}_{{Z}_{f}}^{\left[0\right]} , {I}_{{Z}_{f}}^{\left[1\right]} , … , {I}_{{Z}_{f}}^{⌊ {Z}_{f} - 1 ⌋}$ below. All non-negative exponent matrix elements may correspond to circulant permutation matrices, for example the zero exponent permutation matrix may correspond to the identity matrix: $\begin{matrix}{I}_{{Z}_{f}}^{\left[0\right]} = \left[\begin{matrix}1 & 0 & 0 & 0 & . & 0 & 0 & 0 \\ 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \\ 0 & 0 & 0 & 0 & . & 0 & 0 & 1\end{matrix}\right] & {I}_{{Z}_{f}}^{\left[1\right]} = \left[\begin{matrix}0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \\ 0 & 0 & 0 & 0 & . & 0 & 0 & 1 \\ 1 & 0 & 0 & 0 & . & 0 & 0 & 0\end{matrix}\right]\end{matrix}$ ${I}_{{Z}_{f}}^{\left[{Z}_{f}-1\right]} = \left[\begin{matrix}0 & 0 & 0 & 0 & . & 0 & 0 & 1 \\ 1 & 0 & 0 & 0 & . & 0 & 0 & 0 \\ 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0\end{matrix}\right]$

The same benefits may be obtained if the cyclic shift is a cyclic shift to the left instead of to the right.

Each element of the exponent matrix *E*ₑₓₚ of value equal to '-1' may represent a null square matrix of size *Z_{f}xZ_{f}* as shown in matrix ${I}_{{Z}_{f}}^{\left[-1\right]} :$ ${I}_{{Z}_{f}}^{\left[-1\right]} = \left[\begin{matrix}0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \\ . & . & . & . & . & . & . & . \\ 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0\end{matrix}\right]$

For example, the exponent matrix *E*ₑₓₚ may be of the form:

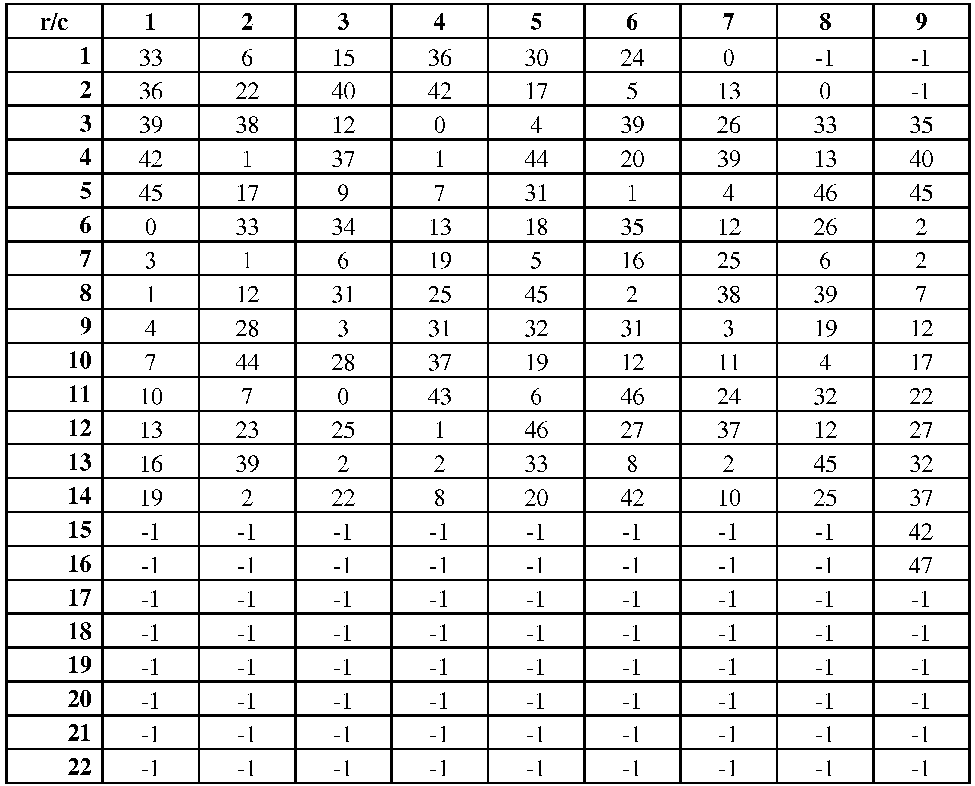

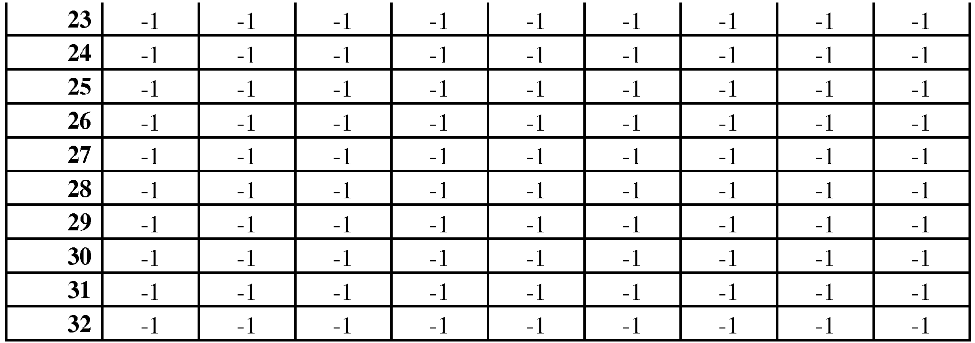

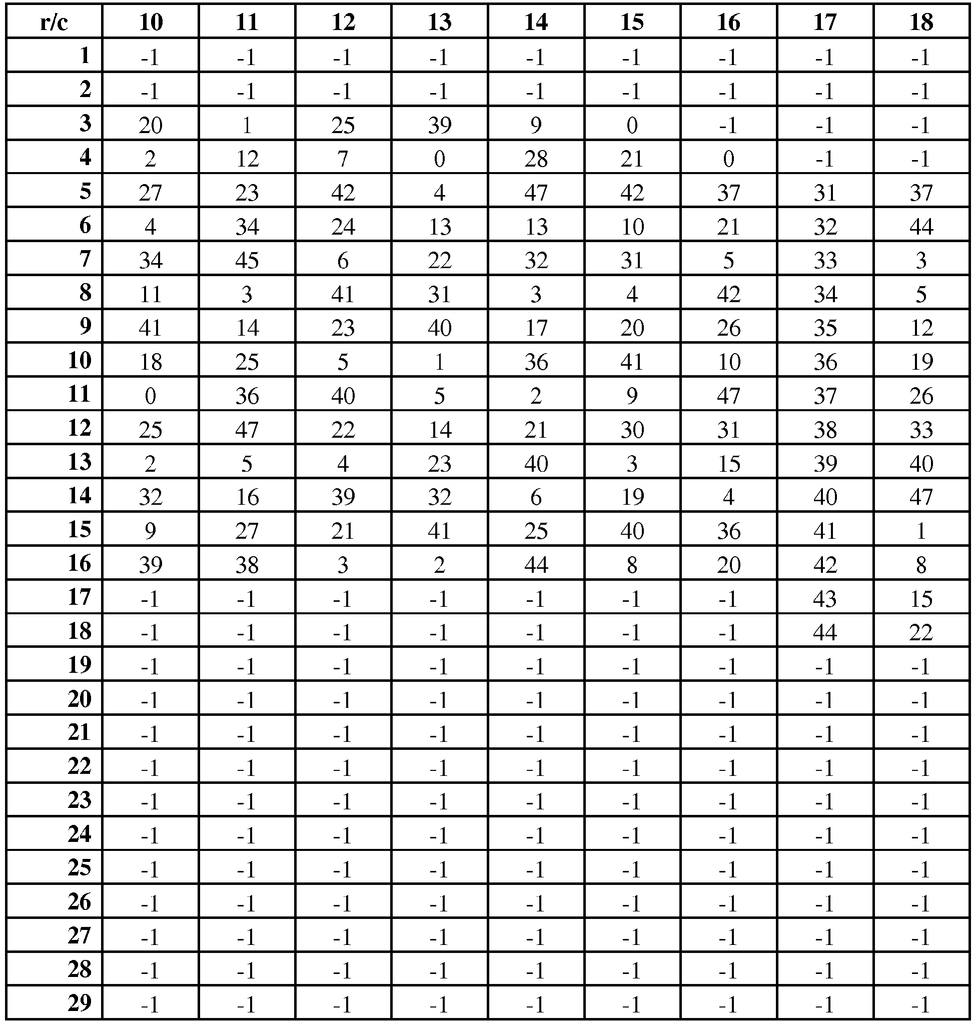

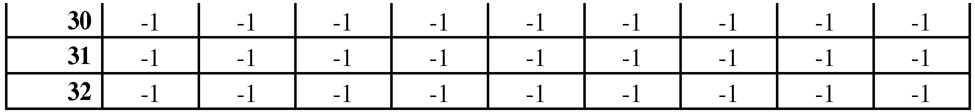

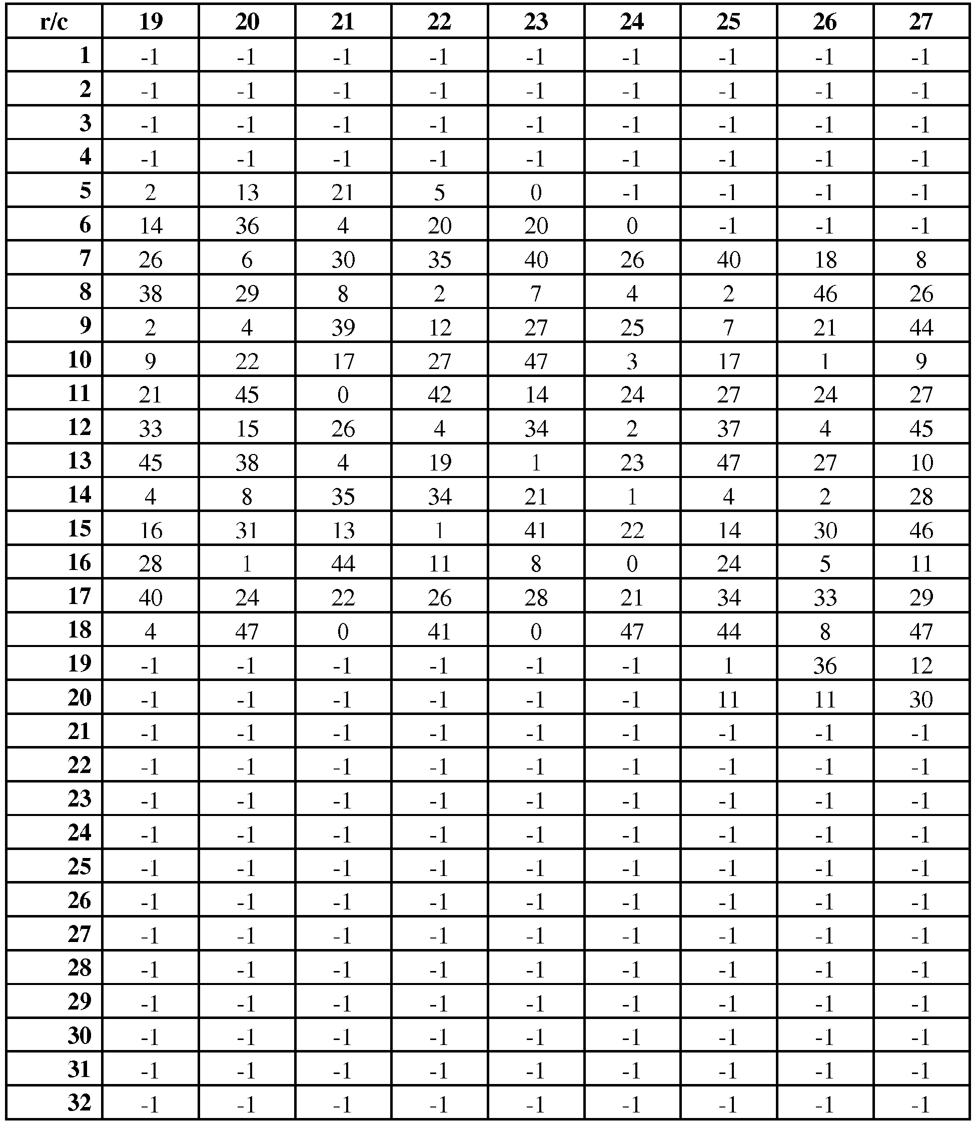

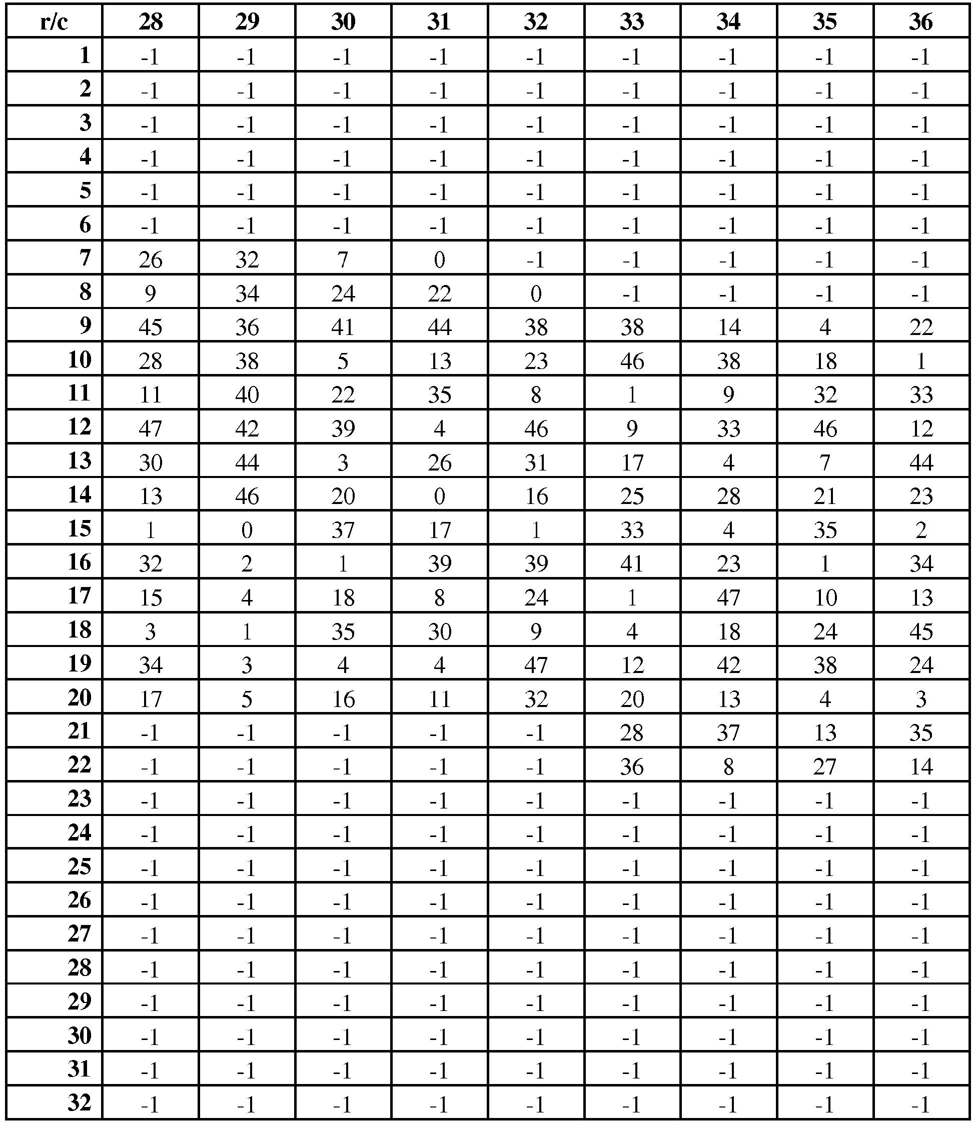

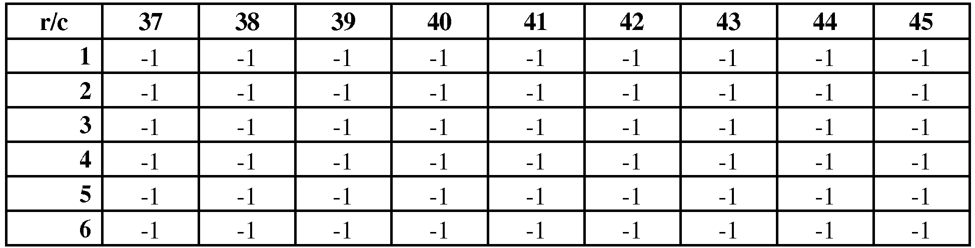

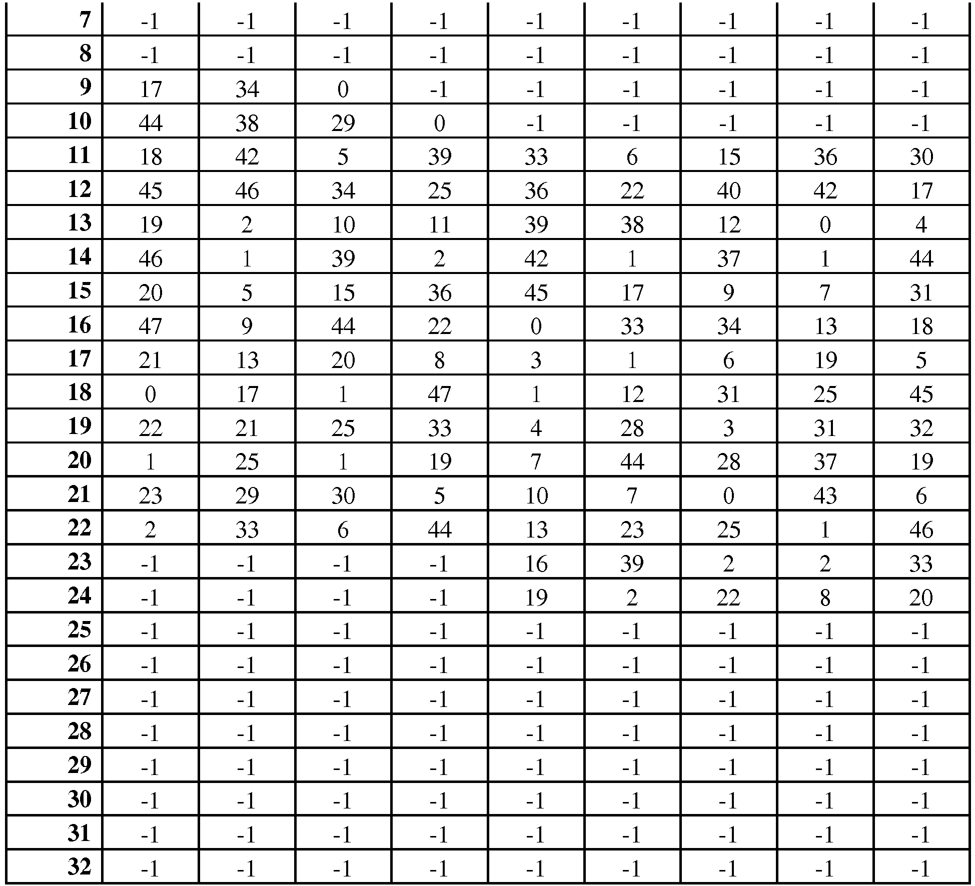

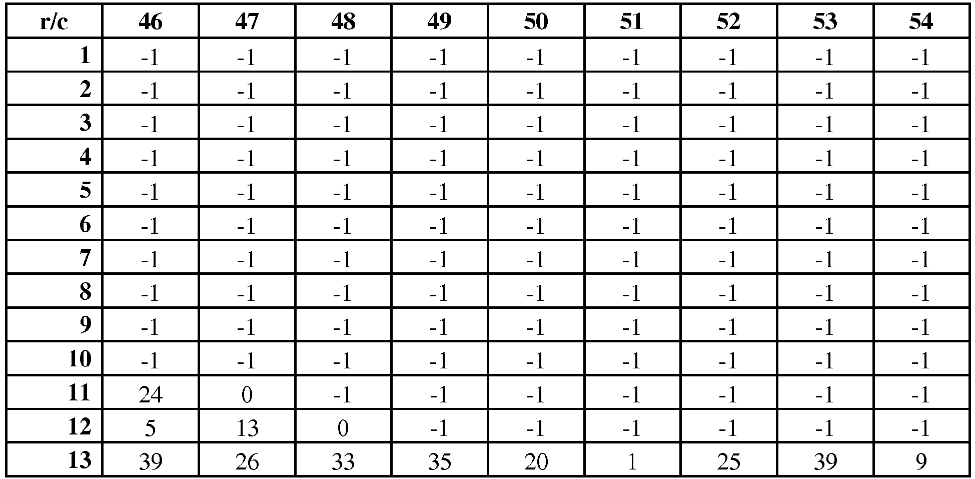

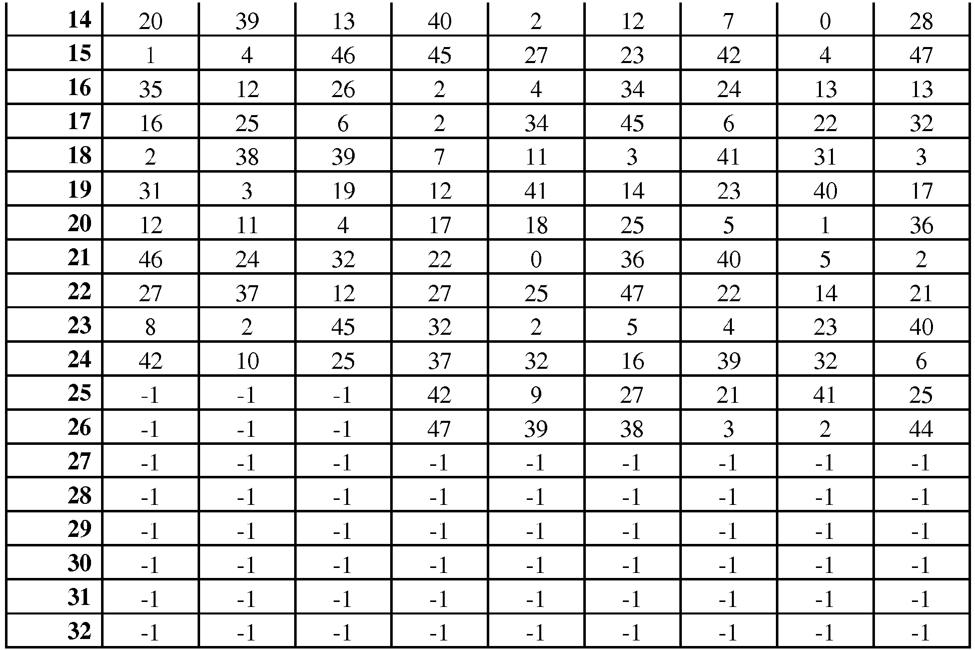

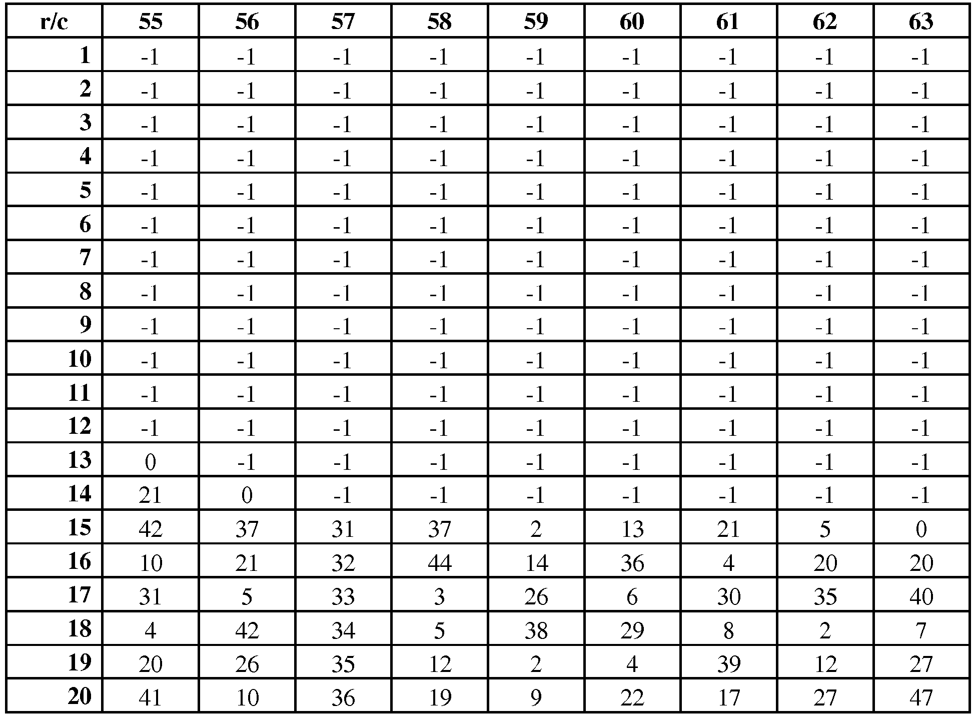

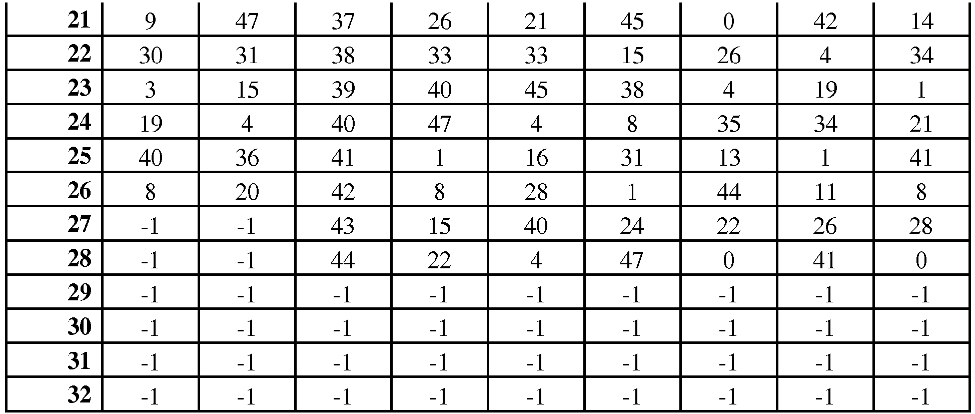

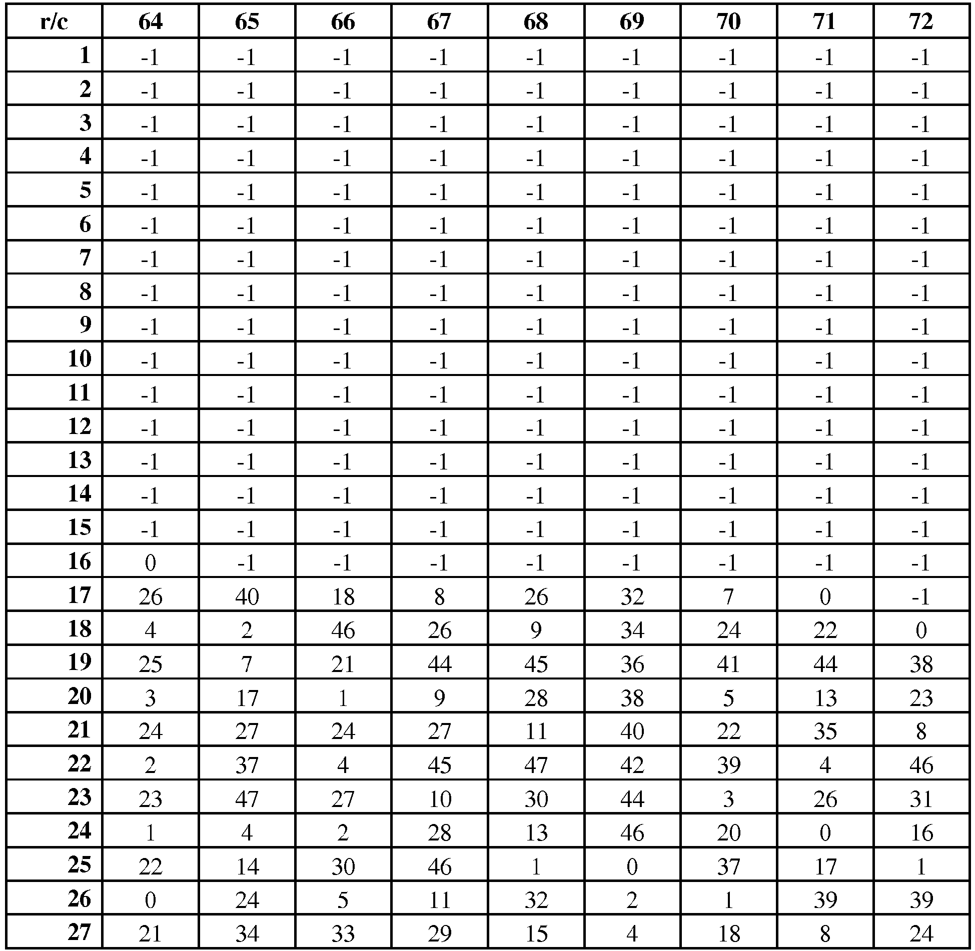

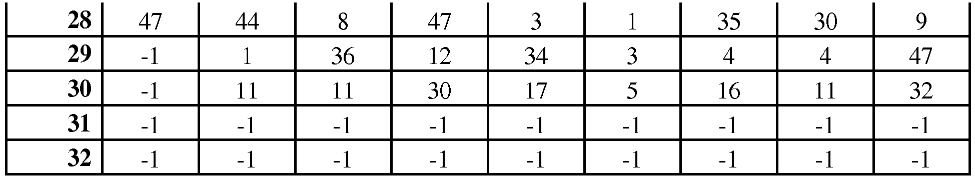

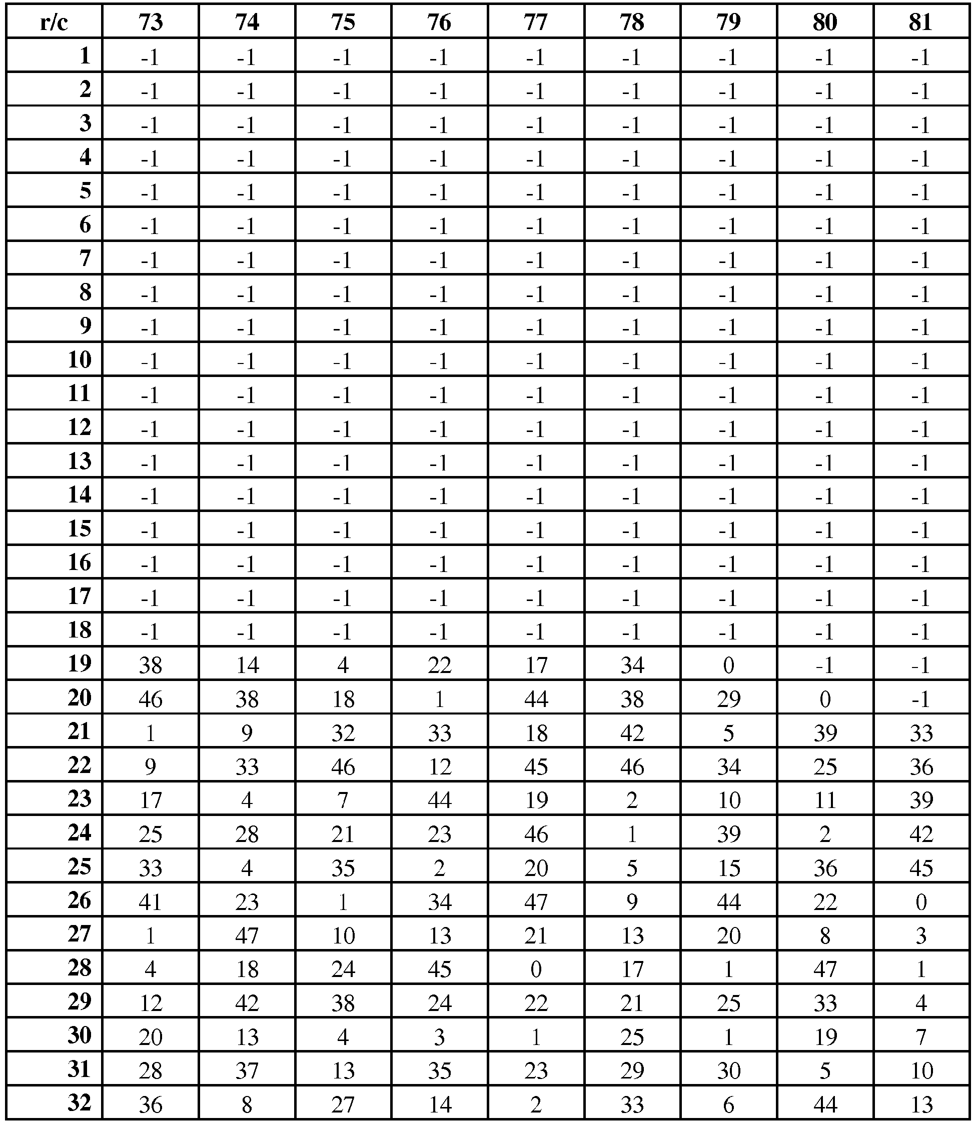

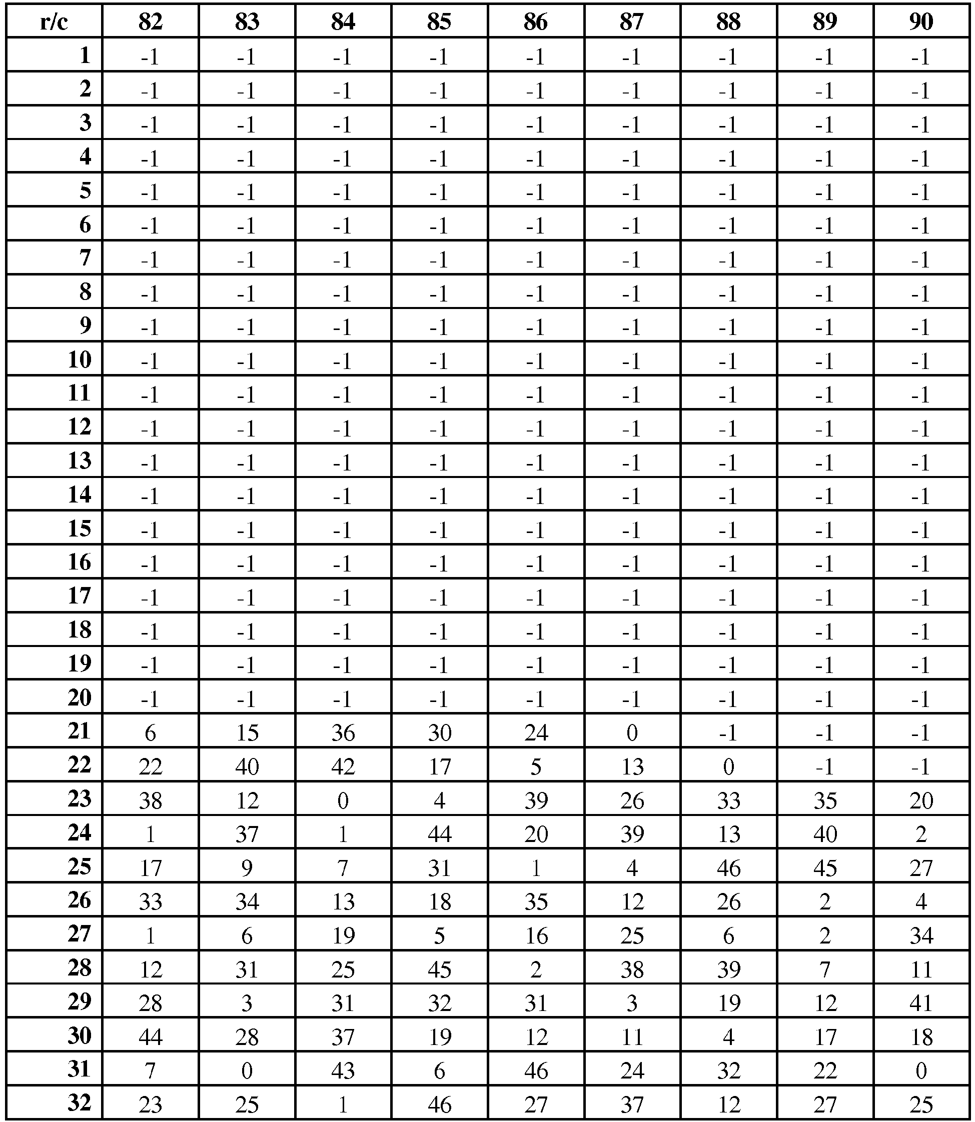

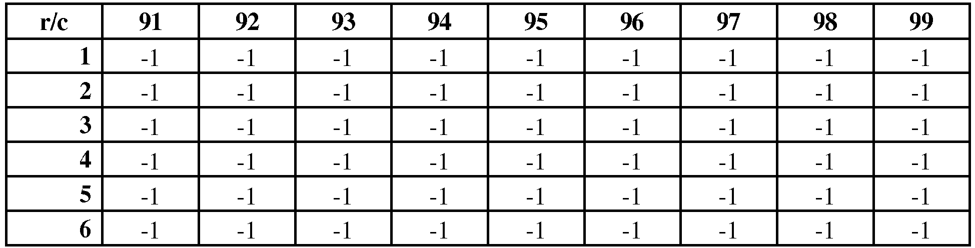

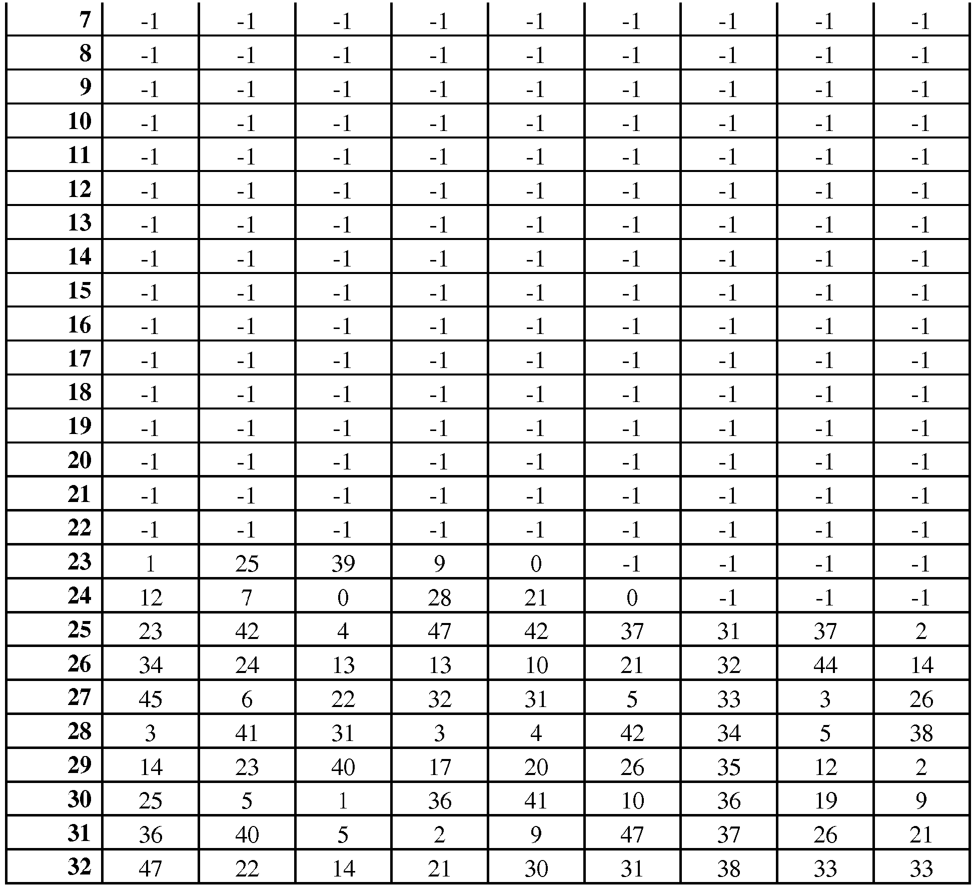

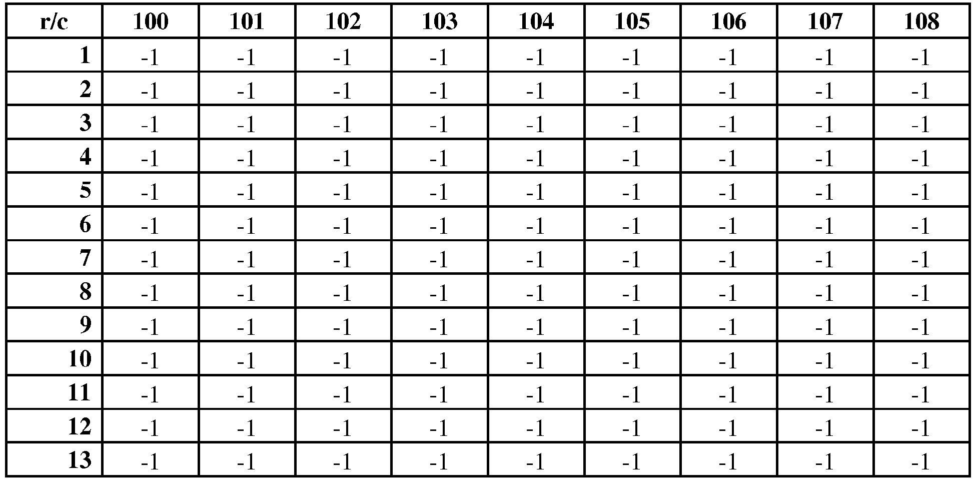

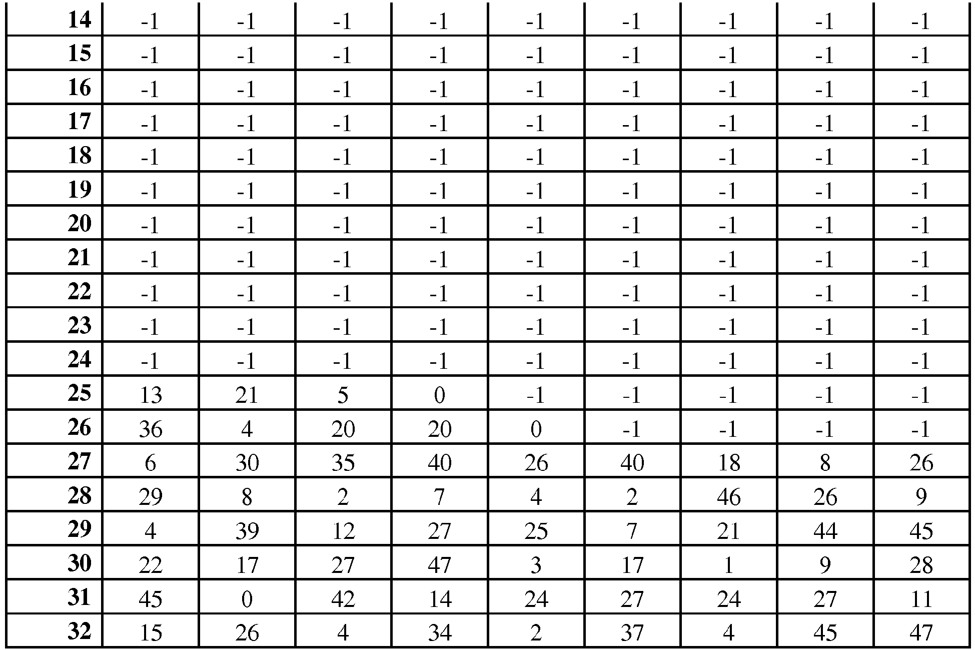

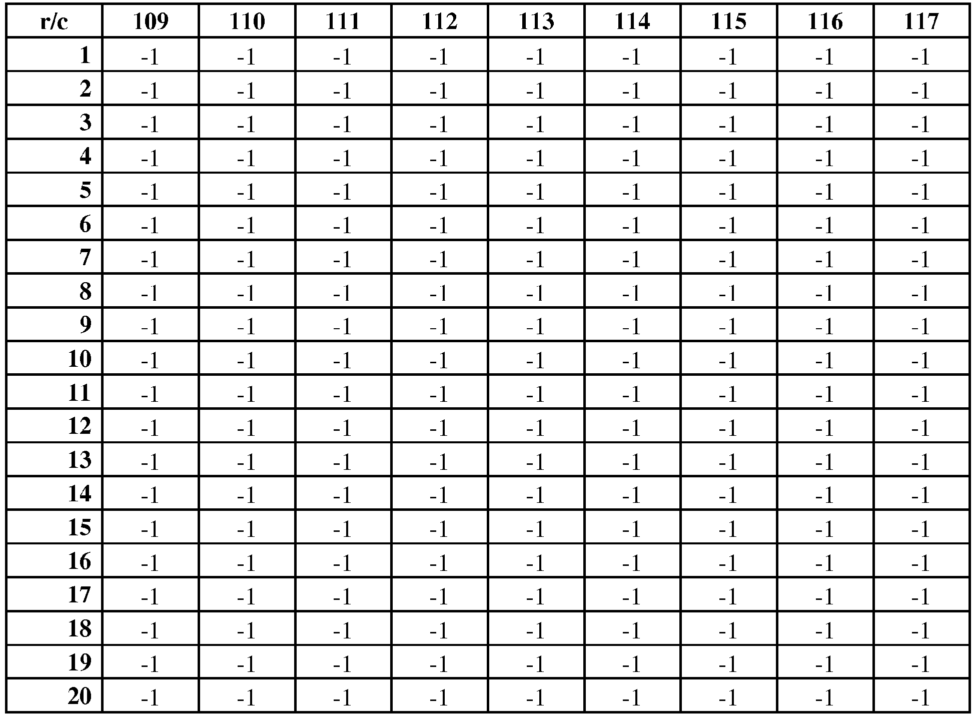

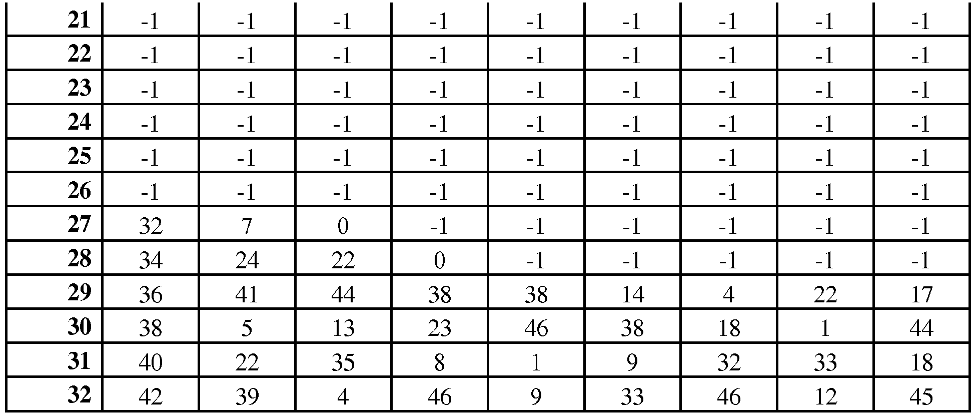

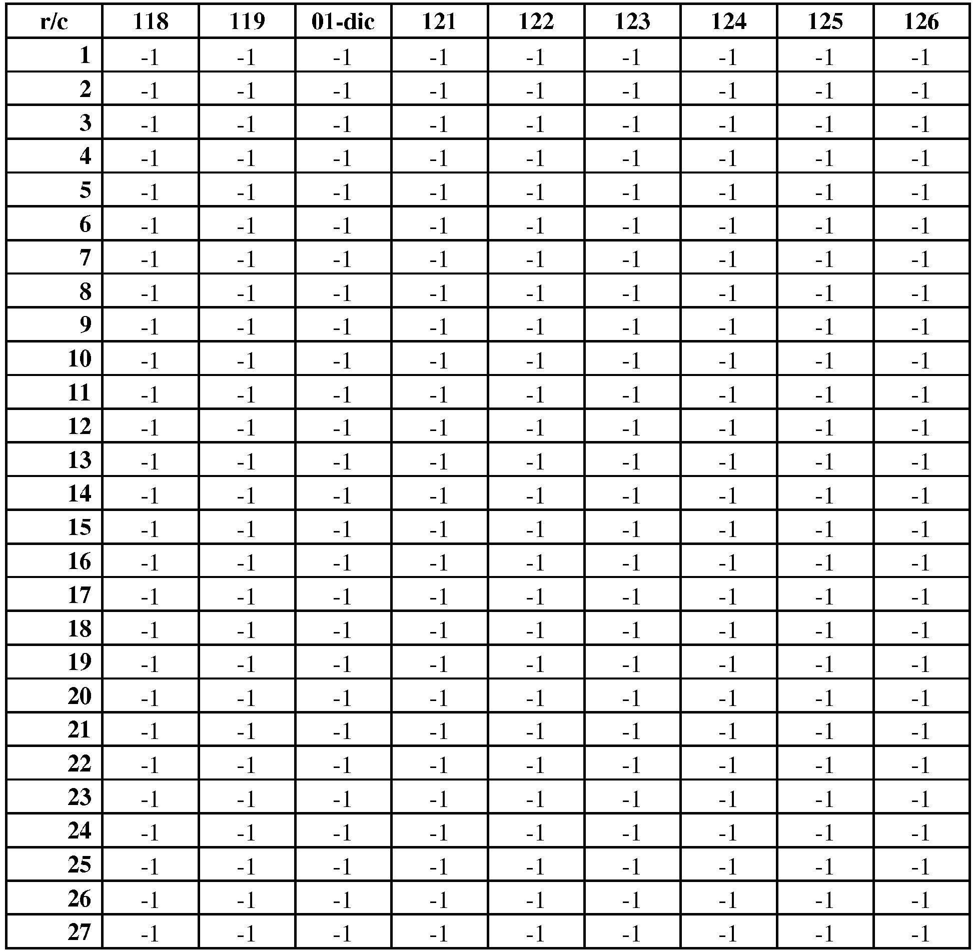

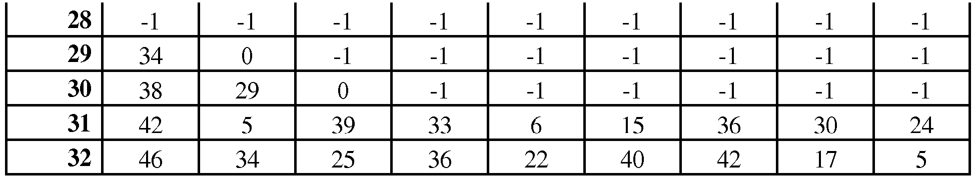

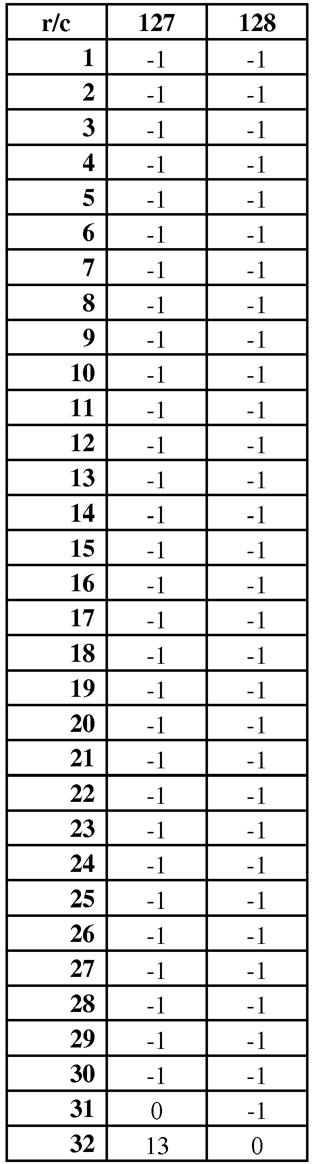

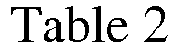

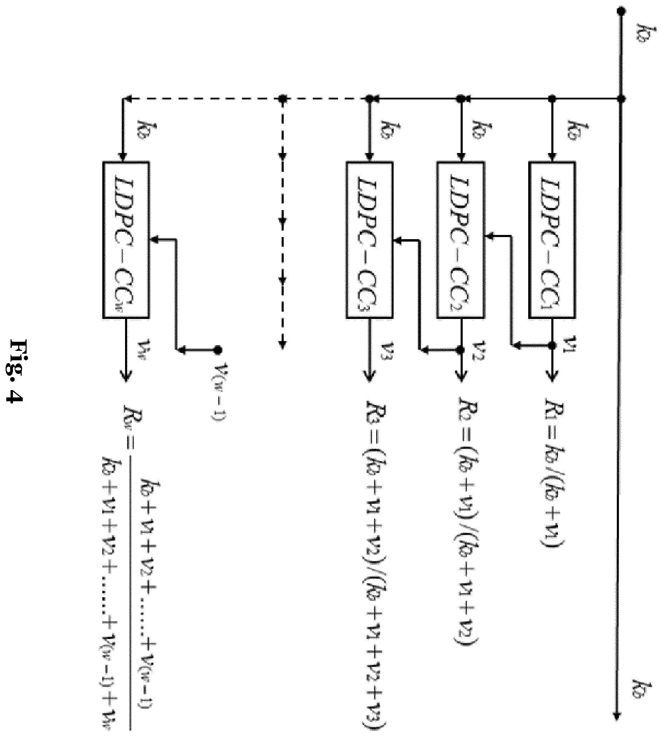

Fig. 4 illustrates an example of an encoding procedure which may be performed by the encoder CH_ENC. The rate of the LDPC-CTC is given by: $R = {R}_{1} ⋅ {R}_{2} ⋅ {R}_{3} ⋅ … ⋅ {R}_{\left(w-1\right)} ⋅ {R}_{w} = \frac{{k}_{b}}{{k}_{b} + {v}_{1} + {v}_{2} + … + {v}_{\left(w-1\right)} + {v}_{w}}$

The LDPC-CTC with rate *R* = *kᵢ*/*n_{c}* is constituted by *w* parallel LDPC-CC codes. The single LDPC-CCs may be designed with the following rates: ${R}_{β} = \frac{\left(w⋅{k}_{i}-1\right) + β}{w ⋅ \left({n}_{c}+1\right) + β} with β = 1 , 2,3 , … , w$

Considering, for example, a LDPC-CTC with rate *R* = *kᵢ*/*n_{c}* = 3/4 and constituted by *w*=4 parallel LDPC-CCs, the single LDPC-CCs have rates *R*₁,*R*₂,*R*₃,*R*₄ which may be computed using equation (12) as: ${R}_{β} = \frac{\left(w⋅{k}_{i}-1\right) + β}{w ⋅ \left({n}_{c}+1\right) + β} = \frac{11 + β}{12 + β} with β = 1 , 2,3 , w = 4$ ${R}_{1} = \frac{12}{13} , {R}_{2} = \frac{13}{14} , {R}_{3} = \frac{14}{15} , {R}_{4} = \frac{15}{16}$

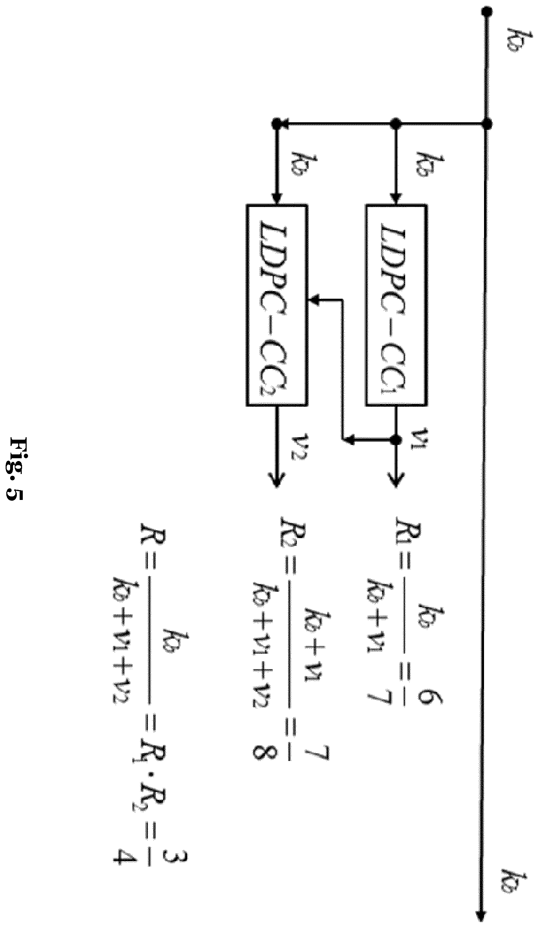

In the implementation example of Fig. 5, a LDPC-CTC with rate *R* = *kᵢ*/*n_{c}*= 3/4 is used, which is based on two (*w* = 2) parallel LDPC-CCs, a first LDPC-CC with rate *R*₁ = *k*_{*i*1}/*n*_{*c*1} = 6/7 and a second LDPC-CC with rate *R*₂ = *k*_{*i*2}/*n*_{*c*2} = 7/8. As indicated above, the number of parallel LDPC-CCs may more than two and be chosen while taking into account the tradeoff between desired performance and hardware complexity.

To build a LDPC-CTC seed matrix as shown in Table 1, the first LDPC-CC seed matrix with rate *R*₁ = 6/7 may be arranged to interlace with the second LDPC-CC seed matrix with rate *R*₂ = 7/8. Arranging the first LDPC-CC seed matrix may comprise adding a (zero) column between consecutive sets of 7 columns of the matrix, wherein the added columns are dedicated to (and will be filled with one or more entries of) the parity sequences of the second LDPC-CC seed matrix with rate *R*₂ = 7/8.

The entries of the rows of the first "arranged" LDPC-CC seed matrix with rate *R*₁ = 6/7 may be copied to the odd rows of the LDPC-CTC seed matrix of Table 1 while the entries of the rows of the second LDPC-CC seed matrix with rate *R*₂ = 7/8 may be copied to the even rows of the LDPC-CTC seed matrix of Table 1.

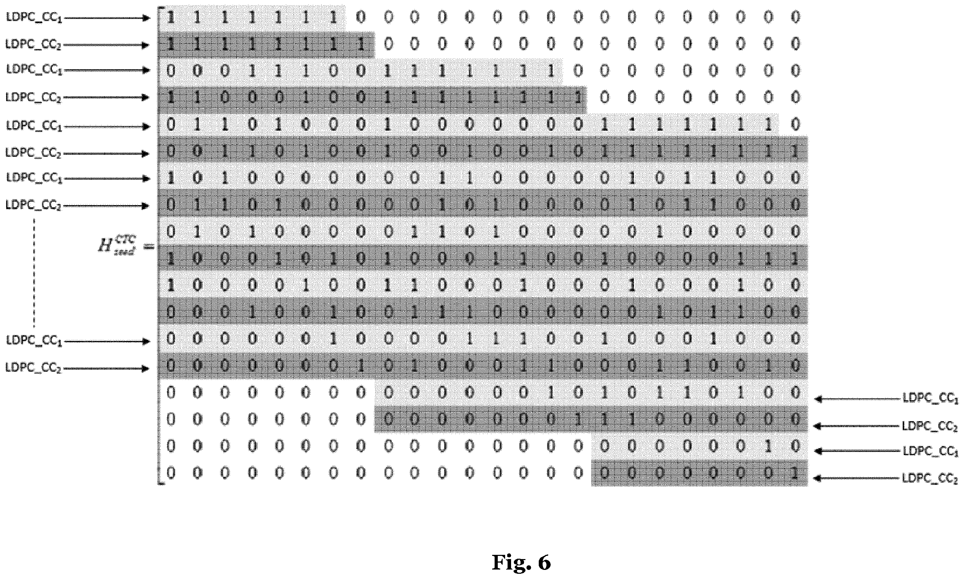

Fig. 6 shows a portion (consisting of 18 rows and 24 columns) of the LDPC-CTC seed matrix of Table 1, wherein the rows filled with entries of the first LDPC-CC seed matrix with rate *R*₁ = 6/7 and the rows filled with entries of the second LDPC-CC seed matrix with rate *R*₂ = 7/8 have been highlighted with using different shades of gray. The following correspondence exists between the rows of the first/second LDPC-CC seed matrix and the rows of the LDPC-CTC seed matrix:

| **First LDPC-CC** | | | **LDPC-CTC** | | |
|---|---|---|---|---|---|
| row | 1 | → | row | 1 | |
| " | 2 | → | " | 3 | |
| " | 3 | → | " | 5 | |
| " | 4 | → | " | 7 | |
| " | 5 | → | " | 9 | |
| " | 6 | → | " | 11 | and so on. |

| **Second LDPC-CC** | | | **LDPC- -CTC)** | | |
|---|---|---|---|---|---|
| row | 1 | → | row | 2 | |
| " | 2 | → | " | 4 | |
| " | 3 | → | " | 6 | |
| " | 4 | → | " | 8 | |
| " | 5 | → | " | 10 | |
| " | 6 | → | " | 12 | and so on. |

Therefore, although the LDPC-CTC may be constructed from several LDPC-CCs placed in parallel form, the LDPC-CTC can be represented by a single seed matrix, a single exponent parity-check matrix and a single binary parity-check matrix, which may be used in the encoding/decoding procedures.

As for LDPC-BCs carried-out with semi-random technique, the exponent parity-check matrix of the LDPC-CTC may be used in the encoding procedure because it takes advantage of the cyclic permutation matrix features. In the decoding process, the binary parity-check matrix of the LDPC-CTC may be used.

For the first LDPC-CC, equation (7), which governs the encoding procedure, remains unchanged and, for a code-rate *R*₁ = 6/7, can be expressed as: ${ \begin{matrix}{v}_{n 1}^{cc 1} = {u}_{n 1} , {v}_{n 2}^{cc 1} = {u}_{n 2} , {v}_{n 3}^{cc 1} = {u}_{n 3} , {v}_{n 4}^{cc 1} = {u}_{n 4} , {v}_{n 5}^{cc 1} = {u}_{n 5} , {v}_{n 6}^{cc 1} = {u}_{n 6} \\ {v}_{n 7}^{cc 1} = {\sum }_{i = 0}^{M} {h}_{1}^{\left(i\right)} \left(n\right) ⋅ {u}_{\left(n-i\right) 1} + {\sum }_{i = 0}^{M} {h}_{2}^{\left(i\right)} \left(n\right) ⋅ {u}_{\left(n-i\right) 2} + … {\sum }_{i = 0}^{M} {h}_{6}^{\left(i\right)} \left(n\right) ⋅ {u}_{\left(n-i\right) 6} + {\sum }_{i = 1}^{M} {h}_{7}^{\left(i\right)} \left(n\right) ⋅ {v}_{\left(i-i\right) 7}\end{matrix}$

For the second LDPC-CC with code rate *R*₂ = 7/8, equation (7) becomes: ${ \begin{matrix}{v}_{n 1}^{cc 2} = {u}_{n 1} , {v}_{n 2}^{cc 2} = {u}_{n 2} , {v}_{n 3}^{cc 2} = {u}_{n 3} , … … , {v}_{n 6}^{cc 2} = {u}_{n 6} , {v}_{n 7}^{cc 2} = {v}_{n 7}^{cc 1} \\ {v}_{n 8}^{cc 2} = {\sum }_{i = 0}^{M} {γ}_{1}^{\left(i\right)} \left(n\right) ⋅ {u}_{\left(n-i\right) 1} + {\sum }_{i = 0}^{M} {γ}_{2}^{\left(i\right)} \left(n\right) ⋅ {u}_{\left(n-i\right) 2} + … {\sum }_{i = 0}^{M} {γ}_{7}^{\left(i\right)} \left(n\right) ⋅ {v}_{\left(n-1\right) 7}^{cc 1} + {\sum }_{i = 1}^{M} {γ}_{8}^{\left(i\right)} \left(n\right) ⋅ {v}_{\left(n-i\right) 8}^{cc 2}\end{matrix}$

To carry-out the LDPC-CTC encoding procedure, equation (15) and equation (16) may be rearranged as: ${ \begin{matrix}{v}_{n 1}^{cc 2} = {v}_{n 1}^{cc 1} = {u}_{n 1} , {v}_{n 2}^{cc 2} = {v}_{n 2}^{cc 1} = {u}_{n 2} , … … , {v}_{n 5}^{cc 2} = {v}_{n 5}^{cc 1} = {u}_{n 5} , {v}_{n 6}^{cc 2} = {v}_{n 6}^{cc 1} = {u}_{n 6} \\ {v}_{n 7}^{cc 1} = {\sum }_{i = 0}^{M} {h}_{1}^{\left(i\right)} \left(n\right) ⋅ {u}_{\left(n-i\right) 1} + {\sum }_{i = 0}^{M} {h}_{2}^{\left(i\right)} \left(n\right) ⋅ {u}_{\left(n-i\right) 2} + … + {\sum }_{i = 0}^{M} {h}_{6}^{\left(i\right)} \left(n\right) ⋅ {u}_{\left(n-i\right) 6} + {\sum }_{i = 1}^{M} {h}_{7}^{\left(i\right)} \left(n\right) ⋅ {v}_{\left(n-i\right) 7}^{cc 1} \\ {v}_{n 8}^{cc 2} = {\sum }_{i = 0}^{M} {γ}_{1}^{\left(i\right)} \left(n\right) ⋅ {u}_{\left(n-i\right) 1} + {\sum }_{i = 0}^{M} {γ}_{2}^{\left(i\right)} \left(n\right) ⋅ {u}_{\left(n-i\right) 2} + … + {\sum }_{i = 0}^{M} {γ}_{7}^{\left(i\right)} \left(n\right) ⋅ {v}_{\left(n-i\right) 7} + {\sum }_{i = 1}^{M} {γ}_{8}^{\left(i\right)} \left(n\right) ⋅ {v}_{\left(n-i\right) 8}^{cc 2}\end{matrix}$

Equation (17) allows to carry-out the LDPC-CTC encoding procedure with a code-rate *R* = *R*₁ · *R*₂ = (6/7) · (7/8) = 3/4.

Thus, the LDPC-CTC seed matrix in Table 1 may be masked with the full exponent matrix *E*ₑₓₚ in Table 2 for the rate *R* and expanded with a spreading matrix (cyclic permutation matrix) to produce a binary parity-check matrix *Hᵣₓₙ* of the LDPC-CTC which allows parallel layered decoding with good performance (fast convergence of the belief propagation algorithm) and low decoding latency.

In this regard, it is noted that the code-rate of a LDPC-CTC for tail-biting (TB-LDPC-CTC) is tied to the rate of the code *R* = *kᵢ*/*n_{c}*, the parallel LDPC-CC number *w*, the code period length *T,* the code period number *p* and the parity element number *r* = *n_{c}*-*kᵢ*.

The LDPC-CTC seed matrix of Table 1 masked with the full exponent matrix *E*ₑₓₚ of Table 2 has the following characteristics:

| | | |
|---|---|---|
| *p·w·n_{c}·T*+*w·n_{c}* = (*p·T*+1)*·w·n_{c}* | ⇒ | Exponent parity-check matrix column number |
| (*p*-1)·*w*·*kᵢ·T* | ⇒ | Information column number for tail-biting |
| *p·w·r·T* + *w·r* = (*p·T*+1)·*w·r* | ⇒ | Exponent parity-check matrix row number |
| *H*ₑₓₚ((*p·T*+1)·*w·r,*(*p·T*+1)·*w·n_{c}*) | ⇒ | Exponent parity-check matrix size |

The rate for the TB-LPCC-CTC becomes: ${R}_{TB}^{CTC} = \frac{\left(p-1\right) ⋅ w ⋅ {k}_{i} ⋅ T}{\left(p-1\right) ⋅ w ⋅ {k}_{i} ⋅ T + \left(p⋅T+1\right) ⋅ w ⋅ r} = \frac{\left(p-1\right) ⋅ w ⋅ {k}_{i} ⋅ T}{\left(p⋅{n}_{c}-{k}_{i}\right) ⋅ w ⋅ T + \left({n}_{c}-{k}_{i}\right) ⋅ w}$

The LDPC-CTC seed matrix of Table 1 masked with the full exponent matrix *E*ₑₓₚ of Table 2 is periodic for rows and for columns. The periodicity of the rows is equal to the product *w*·*r·T* = *w*·(*n_{c}-kᵢ*)*·T* =10 while the periodicity of the columns is equal to the product *w*·*n_{c}*·*T* = 40. Thus, it is not necessary to store the exponent parity-check matrix *H*ₑₓₚ and the binary parity-check matrix *Hᵣₓₙ* in their real size, but it suffices to store *w·r·T* = 10 rows for the exponent matrix and *w*·*r*·*T·Z_{f}* = 10·48 = 480 rows for the binary matrix.

In order to construct the exponent matrix, using well-known construction rules, it may be operated on columns because this allows using 40 incremental steps (unlike the same operation for rows which would only allow using 10 incremental steps). By operating on columns, it may hence be possible to reduce the number of cycles with length 4 in the exponent parity matrix and consequently to improve the code performance. I.e., the increase of the number of incremental steps in the exponent parity matrix construction may allow to achieve an overlap factor (the scalar product between any two columns of the binary parity-check matrix *Hᵣₓₙ*) less than or equal to '1' (≤1).

An overlap factor≤1 makes the LDPC-CC robust, i.e. avoids cycles of length 4 which may degrade performance of the iterative decoding algorithm which reduces code performance.

In the encoding procedure, the exponent parity-check matrix *H*ₑₓₚ may be used to take advantage of the following properties:
- the product between two permutation matrixes of the identity matrix with exponents *α* and *β* produces always a permutation matrix of the identity matrix with exponent (*α* + *β*); and
- the product between a cyclic permutation matrix of the identity matrix with exponent *α* and a vector of size *Z_{f}* produces the same vector of size *Z_{f}* but with a cyclic shift of its elements equal to *α*.

In the decoding procedure, the binary parity-check matrix may be used, because the iterative algorithm updates the single reliability value which corresponds to the single bit.

With the block structured information sequence being denoted by *U*_{[0,*n*]} and the block structured encoded sequence being denoted by V_{[0,*n*]}: ${U}_{\left[0, n\right]} = \left[{U}_{01},{U}_{02},…,{U}_{06},{U}_{11},{U}_{12},…{U}_{16},…,{U}_{n 1},{U}_{n 2},…,{U}_{n 6}\right]$ ${V}_{\left[0, n\right]} = \left[{V}_{01},{V}_{02},…,{V}_{06},{V}_{07},{V}_{08},{V}_{11},{V}_{12},…,{V}_{16},{V}_{17},{V}_{18},…,{V}_{n 1},{V}_{n 2},…,{V}_{n 6},{V}_{n 7},{V}_{n 8}\right]$ the single elements {*Uᵢⱼ, Vᵢⱼ*} are vectors of size equal to spreading factor *Z_{f}* = 48 and the received sequence will be correct, if the following equation will be satisfied: ${\hat{V}}_{\left[0, n\right]} ⋅ {H}_{exp}^{T} = 0$

The systematic block structured LDPC-CTC encoding procedure derived from equation (17) may be carried-out based on: ${ \begin{matrix}{V}_{n 1} = {U}_{n 1} , {V}_{n 2} = {U}_{n 2} , … , {V}_{n 5} = {U}_{n 5} , {V}_{n 6} = {U}_{n 6} \\ {V}_{n 7} = {\sum }_{i = 0}^{M} {H}_{1}^{\left(i\right)} \left(n\right) ⋅ {U}_{\left(n-i\right) 1} + {\sum }_{i = 0}^{M} {H}_{2}^{\left(i\right)} \left(n\right) ⋅ {U}_{\left(n-i\right) 2} + … … + {\sum }_{i = 0}^{M} {H}_{6}^{\left(i\right)} \left(n\right) ⋅ {U}_{\left(n-i\right) 6} + {\sum }_{i = 1}^{M} {H}_{7}^{\left(i\right)} \left(n\right) ⋅ {V}_{\left(n-i\right) 7} \\ {V}_{n 8} = {\sum }_{i = 0}^{M} {Γ}_{1}^{\left(i\right)} \left(n\right) ⋅ {U}_{\left(n-i\right) 1} + {\sum }_{i = 0}^{M} {Γ}_{2}^{\left(i\right)} \left(n\right) ⋅ {U}_{\left(n-i\right) 2} + … … + {\sum }_{i = 0}^{M} {Γ}_{7}^{\left(i\right)} \left(n\right) ⋅ {V}_{n 7} + {\sum }_{i = 1}^{M} {Γ}_{8}^{\left(i\right)} \left(n\right) ⋅ {V}_{\left(n-i\right) 8}\end{matrix}$

In the example, the exponent ${H}_{1}^{\left(i\right)} \left(n\right) , {H}_{2}^{\left(i\right)} \left(n\right) , … … , {H}_{6}^{\left(i\right)} \left(n\right) , {H}_{7}^{\left(i\right)} \left(n\right)$ and ${Γ}_{1}^{\left(i\right)} \left(n\right) , {Γ}_{2}^{\left(i\right)} \left(n\right) , … … , {Γ}_{7}^{\left(i\right)} \left(n\right) , {Γ}_{8}^{\left(i\right)} \left(n\right) ,$ of the LDPC-CTC parity-check matrix are cyclic permutation matrices of size *Z_{f}* =48. The coefficients ${H}_{1}^{\left(i\right)} \left(n\right) , {H}_{2}^{\left(i\right)} \left(n\right) , … … , {H}_{6}^{\left(i\right)} \left(n\right)$ and ${Γ}_{1}^{\left(i\right)} \left(n\right) , {Γ}_{2}^{\left(i\right)} \left(n\right) , … … , {Γ}_{7}^{\left(i\right)} \left(n\right)$ are tied to the information sequence while the coefficients ${H}_{7}^{\left(i\right)} \left(n\right)$ and ${Γ}_{8}^{\left(i\right)} \left(n\right)$ are tied to the parity sequence, respectively, of the first LDPC-CC and the second LDPC-CC. Each time slot *n* = 0,1,2,3,... corresponds to a block of *w·n_{c}·Z_{f}* = 384 bits (with *w·kᵢ*·*Z_{f}* = 288 information bits and *w·r·Z_{f}* = 96 parity bits).

The coefficients ${H}_{j}^{\left(i\right)} \left(n\right) , {Γ}_{j}^{\left(i\right)} \left(n\right)$ are always comprised between '0' and (*Z_{f}* -1)=47, but the coefficients ${H}_{7}^{\left(0\right)} \left(n\right) , {Γ}_{8}^{\left(0\right)} \left(n\right) ,$ which correspond to the parity columns of the exponent matrix, may be set equal to '0' to minimize the hardware complexity of the LDPC-CTC encoding process. Hence, the coefficient ${H}_{7}^{\left(0\right)} \left(n\right) , {Γ}_{8}^{\left(0\right)} \left(n\right)$ may correspond to the identity matrix.

In other words, to reduce the number of arithmetic operations in the LDPC-CTC encoding procedure, the exponent parity-check matrix may be constructed by putting to '0' (cyclic permutation matrix equal to the identity matrix) the last exponent (rightmost element) of each row ( ${H}_{7}^{\left(0\right)} \left(n\right) , {Γ}_{8}^{\left(0\right)} \left(n\right)$ for all time slots *n* = 0,1,2,3,....) corresponding to the encoded parity sequence.

As communication services may require different degrees of latency, according to circumstances/transmission requirements like real-time broadcasting, time sensitive service and fast responsiveness of networks for the tactile internet, the internet of things (IoT), etc. and the encoding/decoding procedures may represent the predominant reason for latency introduced to the system, a possibility to adapt the latency introduced by the encoding/decoding procedures may be beneficial.

Current systems usually support different requirements regarding latency and a dynamic change of latency by exchanging information between the decoder CH_DEC and the encoder CH_ENC. This exchange of control messages can be time consuming and produce overhead in the network which leads to low performance of the procedure.

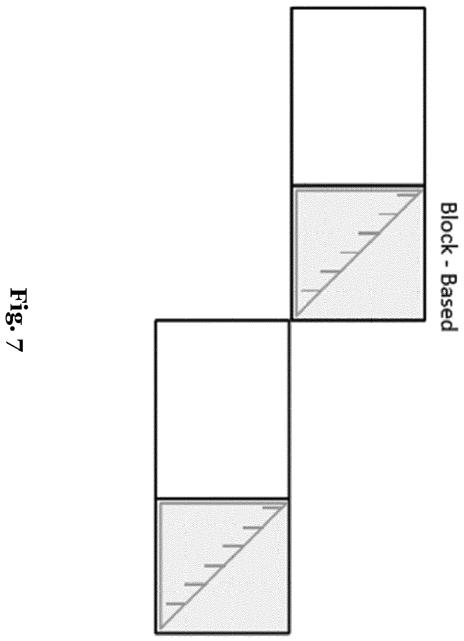

The control messages may include information regarding a modified encoding matrix, i.e., an encoding matrix of another size that permits the encoder to reduce the length *n*' of the code-word, where *n'*≠ *n* to obtain a (substantial) change in the latency. In case of block codes, the consecutive blocks are encoded independently of each other and decoding cannot start before the complete frame of *n* bits is available at the input of the decoder. This approach, which is illustrated in Fig. 7, may be referred to as block-based decoding.

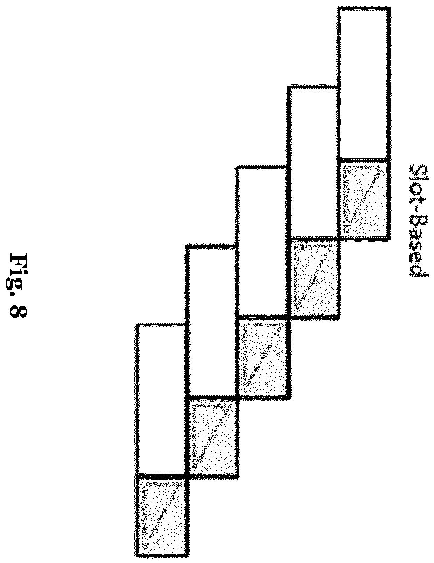

As with LDPC-CCs, the encoding procedure depends on several input blocks in accordance with the memory of the code. The input block length for convolutional codes may be, for example, in the order of a few information bits. The decoding can be performed as soon as the first parity bit is available at the decoder CH_DEC. This approach, which is illustrated in Fig. 8, may be referred to as slot-based decoding.

To perform a slot-based decoding procedure and to exploit the small structural latency of LDPC-CC, a modified decoding procedure is used. The inner core of the decoding procedure is based on a simplified version of the standard BPA but the IN-OUT memories are managed in a different manner.

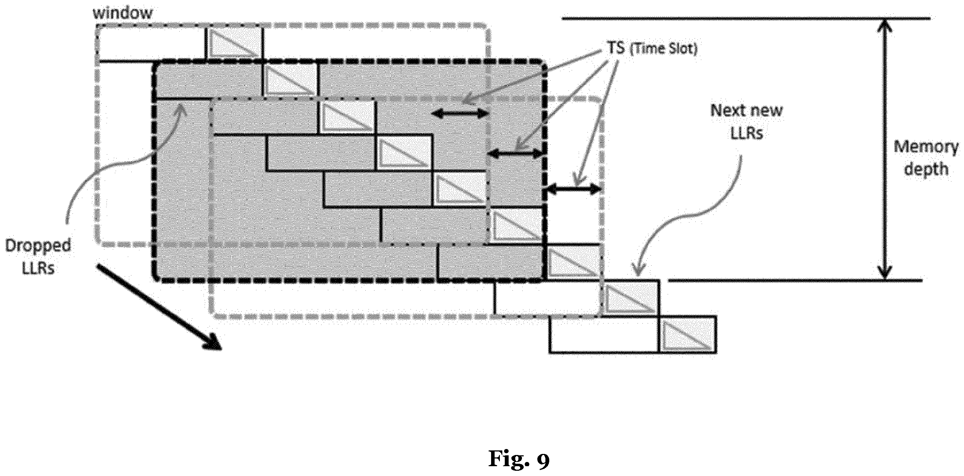

As illustrated in Fig. 9, a single iteration is performed starting from the last new LLRs acquired in the current TS and decoding involves updating the statistical values up to the last LLRs memorized (wherein the memorized LLRs may correspond to several code periods depending on the memory depth). Old LLRs in the memory of the decoder CH_DEC are iterated several times and can be dropped out from the memory according to the desired latency/performance.

The latency involved in carrying-out of the decoding procedure can be modified by the decoder CH_DEC without a need to inform the encoder CH_ENC, as no change of the encoding matrix is required and the size of the parity-check matrix of the LDPC-CTC is independent of the code-word length.

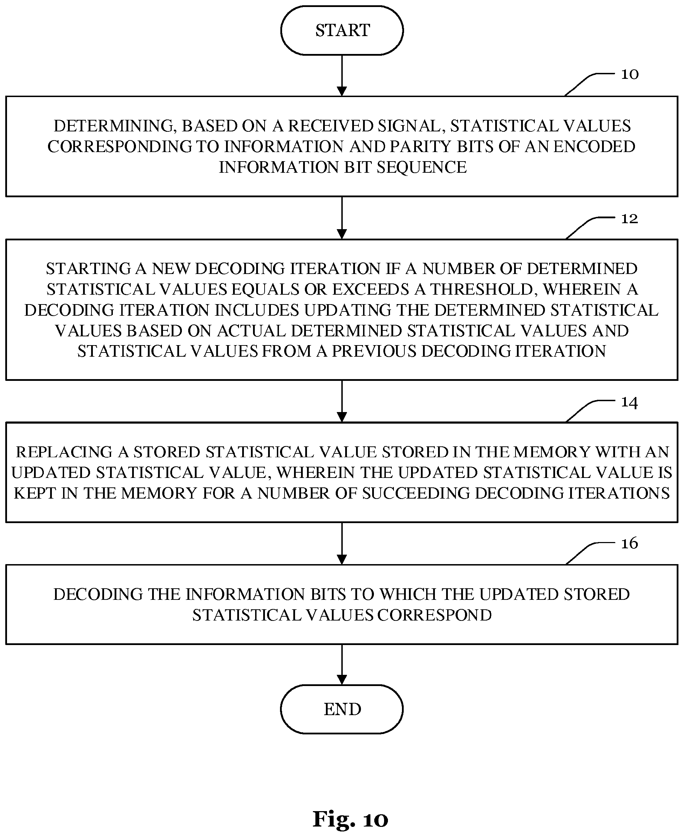

Fig. 10 shows a flow chart of steps of the decoding procedure. After having received the channel output CH_OUT, the demodulator DEM (which may be integrated into the decoder CH_DEC or into separate device) may demodulate the channel output CH_OUT and the decoding procedure may start at the decoder CH_DEC by determining LLRs corresponding to the information and parity bits of the binary word A2, as indicated at step 10 of the flowchart shown in Fig. 10. The length of the binary word A2 may be equal to the length of a TS.

Once one or more LLRs for the parity bits of the binary word A2 have been determined, a new decoding iteration may be started as indicated in step 12 of the flowchart shown in Fig. 10. As shown in Fig. 9, the LLRs which are currently kept in the memory of the decoder CH_DEC may be updated (e.g., based on a turbo decoding procedure) and once the decoding operation has been completed, the sliding window may be advanced by one layer and the LLRs corresponding to the last layer that is dropped may be removed from the memory to provide space for LLRs of the new layer.

The LLRs of the to-be-dropped columns may be used to make a hard decision on the received information bits as indicated at step 16. If the latency/memory requirements are to be adapted, the memory depth may be modified as indicated in Fig. 9.

## Claims

1. A decoder for decoding a low-density parity-check convolutional turbo code, LDPC-CTC, wherein the LDPC-CTC is constructed based on parallel low-density parity-check convolutional codes, LDPC-CCs, the decoder being configured to:
determine, based on a received signal, statistical values corresponding to information and parity bits of an encoded information bit sequence; wherein the statistical values refer to reliability values corresponding to received information and parity bits, wherein a reliability value is a likelihood, likelihood ratio, or log likelihood ratio, and indicates the reliability of making a correct decision if mapping the received signal to a particular bit value;
start a new decoding iteration if a number of determined statistical values equals or exceeds a threshold, wherein a decoding iteration includes updating the determined statistical values based on actual determined statistical values and statistical values from a previous decoding iteration stored in a memory of the decoder; wherein the threshold equals the number of information and parity bits of one layer of the LDPC-CTC; wherein said one layer refers to one row for each LDPC-CC matrix on which the LDPC-CTC is based;
replace a stored statistical value stored in the memory with an updated statistical value, wherein the updated statistical value is kept in the memory for a number of succeeding decoding iterations; and
decode the information bits to which the updated stored statistical values correspond.

2. The decoder of claim 1, wherein the decoder is further configured to:
remove/overwrite the updated stored statistical values from/in the memory of the decoder after the succeeding decoding iterations have been performed and the information bits corresponding to the updated stored statistical value have been decoded.

3. The decoder of claim 1 or 2, wherein the decoder is further configured to:
adapt the number of succeeding decoding operations for which the updated statistical values are kept in the memory of the decoder.

4. The decoder of claim 3, wherein the decoder is further configured to:
decrease the number of succeeding decoding operations for which the updated statistical values are kept in the memory of the decoder in response to a request to reduce a latency of the decoding operation.

5. The decoder of claim 3, wherein the decoder is further configured to:
increase the number of succeeding decoding operations for which the updated statistical values are kept in the memory of the decoder in response to a request to reduce an error rate of the decoding operation.

6. The decoder of any one of claims 1 to 5, wherein updating the statistical values based on the statistical values and statistical values from a previous decoding iteration stored in a memory of the decoder includes parallelly updating different sets of statistical values assigned to different parity bits.

7. A method of decoding a low-density parity-check convolutional turbo code, LDPC-CTC, wherein the LDPC-CTC is constructed based on parallel low-density parity-check convolutional codes, LDPC-CCs, the method comprising:
Determining (10), based on a received signal, statistical values corresponding to information and parity bits of an encoded information bit sequence; wherein the statistical values refer to reliability values corresponding to received information and parity bits, wherein a reliability value is a likelihood, likelihood ratio, or log likelihood ratio, and indicates the reliability of making a correct decision if mapping the received signal to a particular bit value;
starting (12) a new decoding iteration if a number of determined statistical values equals or exceeds a threshold, wherein a decoding iteration includes updating the determined statistical values based on actual determined statistical values and statistical values from a previous decoding iteration; wherein the threshold equals the number of information and parity bits of one layer of the LDPC-CTC; wherein said one layer refers to one row for each LDPC-CC matrix on which the LDPC-CTC is based;
replacing (14) a stored statistical value stored in the memory with an updated statistical value, wherein the updated statistical value is kept in the memory for a number of succeeding decoding iterations; and
decoding (16) the information bits to which the updated stored statistical values correspond.

8. The method of claim 7, further comprising:
removing/overwriting the updated stored statistical values from/in the memory after the succeeding decoding iterations have been performed and the information bits corresponding to the updated stored statistical value have been decoded.

9. The method of claim 7 or 8, further comprising:
adapting the number of succeeding decoding operations for which the updated statistical values are kept in the memory.

10. The method of claim 9, further comprising:
decreasing the number of succeeding decoding operations for which the updated statistical values are kept in the memory in response to a request to reduce a latency of the decoding operation.

11. The method of claim 9, further comprising:
increasing the number of succeeding decoding operations for which the updated statistical values are kept in the memory in response to a request to reduce an error rate of the decoding operation.

12. The method of any one of claims 7 to 11, wherein updating the statistical values based on the statistical values and statistical values from a previous decoding iteration stored in a memory of the decoder includes parallelly updating different sets of statistical values assigned to different parity bits.

13. A machine-readable medium comprising machine-readable instructions which when carried-out by the machine cause the machine to perform the method of any one of claims 7 to 12.

## Patentansprüche

1. Decoder zum Decodieren eines Faltungsturbocodes zur Paritätsprüfung mit niedriger Dichte, LDPC-CTC, wobei der LDPC-CTC basierend auf parallelen Faltungscodes zur Paritätsprüfung mit niedriger Dichte, LDPC-CCs, aufgebaut ist, wobei der Decoder dazu konfiguriert ist:
basierend auf einem empfangenen Signal statistische Werte zu bestimmen, die Informationen und Paritätsbits einer codierten Informationsbitsequenz entsprechen; wobei sich die statistischen Werte auf Zuverlässigkeitswerte beziehen, die empfangenen Informationen und Paritätsbits entsprechen, wobei ein Zuverlässigkeitswert eine Wahrscheinlichkeit, ein Wahrscheinlichkeitsverhältnis oder ein Protokollwahrscheinlichkeitsverhältnis ist und die Zuverlässigkeit angibt,
eine korrekte Entscheidung zu treffen, wenn das empfangene Signal auf einen bestimmten Bitwert gemappt wird;
eine neue Decodier-Iteration zu starten, wenn eine Anzahl bestimmter statistischer Werte gleich einem Schwellenwert ist oder diesen überschreitet, wobei eine Decodier-Iteration das Aktualisieren der bestimmten statistischen Werte beinhaltet, basierend auf tatsächlich bestimmten statistischen Werten und statistischen Werten aus einer vorhergehenden Decodier-Iteration, die in einem Speicher des Decoders gespeichert sind; wobei der Schwellenwert gleich der Anzahl von Informations- und
Paritätsbits einer Schicht des LDPC-CTC ist; wobei sich die eine Schicht auf eine Zeile für jede LDPC-CC-Matrix bezieht, auf der der LDPC-CTC basiert;
einen gespeicherten statistischen Wert, der in dem Speicher gespeichert ist, durch einen aktualisierten statistischen Wert zu ersetzen, wobei der aktualisierte statistische Wert in dem Speicher für eine Anzahl von aufeinanderfolgenden Decodier-Iterationen gehalten wird; und
die Informationsbits zu decodieren, denen die aktualisierten gespeicherten statistischen Werte entsprechen.

2. Decoder nach Anspruch 1, wobei der Decoder ferner dazu konfiguriert ist:
die aktualisierten gespeicherten statistischen Werte aus dem/im Speicher des Decoders zu entfernen/zu überschreiben, nachdem die aufeinanderfolgenden Decodier-Iterationen durchgeführt worden sind und die dem aktualisierten gespeicherten statistischen Wert entsprechenden Informationsbits decodiert worden sind.

3. Decoder nach Anspruch 1 oder 2, wobei der Decoder ferner dazu konfiguriert ist:
die Anzahl der aufeinanderfolgenden Decodiervorgänge anzupassen, für die die aktualisierten statistischen Werte im Speicher des Decoders gehalten werden.

4. Decoder nach Anspruch 3, wobei der Decoder ferner dazu konfiguriert ist:
die Anzahl der aufeinanderfolgenden Decodiervorgänge, für die die aktualisierten statistischen Werte im Speicher des Decoders gehalten werden, als Reaktion auf eine Anforderung, eine Latenz des Decodiervorgangs zu reduzieren, zu verringern.

5. Decoder nach Anspruch 3, wobei der Decoder ferner dazu konfiguriert ist:
die Anzahl der aufeinanderfolgenden Decodiervorgänge, für die die aktualisierten statistischen Werte im Speicher des Decoders gehalten werden, als Reaktion auf eine Anforderung, eine Fehlerrate des Decodiervorgangs zu reduzieren, zu erhöhen.

6. Decoder nach einem der Ansprüche 1 bis 5, wobei das Aktualisieren der statistischen Werte basierend auf den statistischen Werten und den statistischen Werten aus einer vorhergehenden Dekodier-Iteration, die in einem Speicher des Decoders gespeichert sind, das paralleles Aktualisieren verschiedener Sätze von statistischen Werten beinhaltet, die verschiedenen Paritätsbits zugewiesen sind.

7. Verfahren zum Decodieren eines Faltungsturbocodes zur Paritätsprüfung mit niedriger Dichte, LDPC-CTC, wobei der LDPC-CTC basierend auf parallelen Faltungsturbocodes zur Paritätsprüfung mit niedriger Dichte, LDPC-CCs, aufgebaut ist, wobei das Verfahren umfasst:
Bestimmen (10), basierend auf einem empfangenen Signal statistischer Werte, die Informationen und Paritätsbits einer codierten Informationsbitsequenz entsprechen;
wobei sich die statistischen Werte auf Zuverlässigkeitswerte beziehen, die empfangenen Informationen und Paritätsbits entsprechen, wobei ein Zuverlässigkeitswert eine Wahrscheinlichkeit, ein Wahrscheinlichkeitsverhältnis oder ein Protokollwahrscheinlichkeitsverhältnis ist und die Zuverlässigkeit angibt, eine korrekte Entscheidung zu treffen, wenn das empfangene Signal auf einen bestimmten Bitwert gemappt wird;
Starten (12) einer neuen Decodier-Iteration, wenn eine Anzahl bestimmter statistischer Werte gleich einem Schwellenwert ist oder diesen überschreitet, wobei eine Decodier-Iteration das Aktualisieren der bestimmten statistischen Werte basierend auf tatsächlich bestimmten statistischen Werten und statistischen Werten aus einer vorherigen Decodier-Iteration beinhaltet; wobei der Schwellenwert gleich der Anzahl von Informations- und Paritätsbits einer Schicht des LDPC-CTC ist;
wobei sich die eine Schicht auf eine Zeile für jede LDPC-CC-Matrix bezieht, auf der der LDPC-CTC basiert;
Ersetzen (14) eines gespeicherten statistischen Wertes, der in dem Speicher gespeichert ist, durch einen aktualisierten statistischen Wert, wobei der aktualisierte statistische Wert in dem Speicher für eine Anzahl von aufeinanderfolgenden Decodier-Iterationen gehalten wird; und
Decodieren (16) der Informationsbits, denen die aktualisierten gespeicherten statistischen Werte entsprechen.

8. Verfahren nach Anspruch 7, ferner umfassend:
Entfernen/Überschreiben der aktualisierten gespeicherten statistischen Werte aus dem/im Speicher, nachdem die aufeinanderfolgenden Decodier-Iterationen durchgeführt und die dem aktualisierten gespeicherten statistischen Wert entsprechenden Informationsbits decodiert worden sind.

9. Verfahren nach Anspruch 7 oder 8, ferner umfassend:
Anpassen der Anzahl der aufeinanderfolgenden Decodiervorgänge, für die die aktualisierten statistischen Werte im Speicher gehalten werden.

10. Verfahren nach Anspruch 9, ferner umfassend:
Verringern der Anzahl der aufeinanderfolgenden Decodiervorgänge, für die die aktualisierten statistischen Werte im Speicher gehalten werden, als Reaktion auf eine Anforderung, eine Latenz des Decodiervorgangs zu reduzieren.

11. Verfahren nach Anspruch 9, ferner umfassend:
Erhöhen der Anzahl der aufeinanderfolgenden Decodiervorgänge, für die die aktualisierten statistischen Werte im Speicher gehalten werden, als Reaktion auf eine Anforderung, eine Fehlerrate des Decodiervorgangs zu reduzieren.

12. Verfahren nach einem der Ansprüche 7 bis 11, wobei das Aktualisieren der statistischen Werte basierend auf den statistischen Werten und den statistischen Werten aus einer vorhergehenden Dekodier-Iteration, die in einem Speicher des Decoders gespeichert sind, das paralleles Aktualisieren verschiedener Sätze von statistischen Werten beinhaltet, die verschiedenen Paritätsbits zugewiesen sind.

13. Maschinenlesbares Medium, das maschinenlesbare Befehle umfasst, die, wenn sie von der Maschine durchgeführt werden, die Maschine veranlassen, das Verfahren nach einem der Ansprüche 7 bis 12 durchzuführen.

## Revendications

1. Décodeur pour décoder un turbo-code convolutif de contrôle de parité à faible densité, LDPC-CTC, le LDPC-CTC étant construit sur la base de codes convolutifs de contrôle de parité à faible densité, LDPC-CC, parallèles, le décodeur étant configuré pour :
déterminer, sur la base d'un signal reçu, des valeurs statistiques correspondant à des bits d'informations et de parité d'une séquence de bits d'informations codée ; les valeurs statistiques se référant à des valeurs de fiabilité correspondant à des bits d'informations et de parité reçus, une valeur de fiabilité étant une vraisemblance, un rapport de vraisemblance ou un rapport de vraisemblance logarithmique, et indiquant la fiabilité de la prise d'une décision correcte en cas de mise en correspondance du signal reçu avec une valeur de bit particulière ;
démarrer une nouvelle itération de décodage si un nombre de valeurs statistiques déterminées est égal ou supérieur à un seuil, une itération de décodage comprenant la mise à jour des valeurs statistiques déterminées sur la base de valeurs statistiques déterminées réelles et de valeurs statistiques d'une itération de décodage précédente stockées dans une mémoire du décodeur ; le seuil étant égal au nombre de bits d'informations et de parité d'une couche du LDPC-CTC ; ladite une couche se référant à une rangée pour chaque matrice LDPC-CC sur laquelle le LDPC-CTC est basé ;
remplacer une valeur statistique stockée stockée dans la mémoire par une valeur statistique mise à jour, la valeur statistique mise à jour étant conservée dans la mémoire pour un certain nombre d'itérations de décodage suivantes ; et
décoder les bits d'informations auxquels correspondent les valeurs statistiques stockées mises à jour.

2. Décodeur selon la revendication 1, le décodeur étant en outre configuré pour :
supprimer/réécrire les valeurs statistiques stockées mises à jour de/dans la mémoire du décodeur après que les itérations de décodage suivantes ont été effectuées et que les bits d'informations correspondant à la valeur statistique stockée mise à jour ont été décodés.

3. Décodeur selon la revendication 1 ou 2, le décodeur étant en outre configuré pour :
adapter le nombre d'opérations de décodage suivantes pour lesquelles les valeurs statistiques mises à jour sont conservées dans la mémoire du décodeur.

4. Décodeur selon la revendication 3, le décodeur étant en outre configuré pour :
diminuer le nombre d'opérations de décodage suivantes pour lesquelles les valeurs statistiques mises à jour sont conservées dans la mémoire du décodeur en réponse à une demande de réduction d'une latence de l'opération de décodage.

5. Décodeur selon la revendication 3, le décodeur étant en outre configuré pour :
augmenter le nombre d'opérations de décodage suivantes pour lesquelles les valeurs statistiques mises à jour sont conservées dans la mémoire du décodeur en réponse à une demande de réduction d'un taux d'erreur de l'opération de décodage.

6. Décodeur selon l'une quelconque des revendications 1 à 5, la mise à jour des valeurs statistiques sur la base des valeurs statistiques et des valeurs statistiques d'une itération de décodage précédente stockées dans une mémoire du décodeur comprenant la mise à jour en parallèle de différents ensembles de valeurs statistiques attribuées à différents bits de parité.

7. Procédé de décodage d'un turbo-code convolutif de contrôle de parité à faible densité, LDPC-CTC, le LDPC-CTC étant construit sur la base de codes convolutifs de contrôle de parité à faible densité, LDPC-CC, parallèles, le procédé comprenant les étapes de :
détermination (10), sur la base d'un signal reçu, de valeurs statistiques correspondant à des bits d'informations et de parité d'une séquence de bits d'informations codée ; les valeurs statistiques se référant à des valeurs de fiabilité correspondant à des bits d'informations et de parité reçus, une valeur de fiabilité étant une vraisemblance, un rapport de vraisemblance ou un rapport de vraisemblance logarithmique, et indiquant la fiabilité de la prise d'une décision correcte en cas de mise en correspondance du signal reçu avec une valeur de bit particulière ;
démarrage (12) d'une nouvelle itération de décodage si un nombre de valeurs statistiques déterminées est égal ou supérieur à un seuil, une itération de décodage comprenant la mise à jour des valeurs statistiques déterminées sur la base de valeurs statistiques déterminées réelles et de valeurs statistiques d'une itération de décodage précédente ; le seuil étant égal au nombre de bits d'informations et de parité d'une couche du LDPC-CTC ; ladite une couche se référant à une rangée pour chaque matrice LDPC-CC sur laquelle le LDPC-CTC est basé ;
remplacement (14) d'une valeur statistique stockée stockée dans la mémoire par une valeur statistique mise à jour, la valeur statistique mise à jour étant conservée dans la mémoire pour un certain nombre d'itérations de décodage suivantes ; et
décodage (16) des bits d'informations auxquels correspondent les valeurs statistiques stockées mises à jour.

8. Procédé selon la revendication 7, comprenant en outre :
la suppression/la réécriture des valeurs statistiques stockées mises à jour de/dans la mémoire après que les itérations de décodage suivantes ont été effectuées et que les bits d'informations correspondant à la valeur statistique stockée mise à jour ont été décodés.

9. Procédé selon la revendication 7 ou 8, comprenant en outre :
l'adaptation du nombre d'opérations de décodage suivantes pour lesquelles les valeurs statistiques mises à jour sont conservées dans la mémoire.

10. Procédé selon la revendication 9, comprenant en outre :
la diminution du nombre d'opérations de décodage suivantes pour lesquelles les valeurs statistiques mises à jour sont conservées dans la mémoire en réponse à une demande de réduction d'une latence de l'opération de décodage.

11. Procédé selon la revendication 9, comprenant en outre :
l'augmentation du nombre d'opérations de décodage suivantes pour lesquelles les valeurs statistiques mises à jour sont conservées dans la mémoire en réponse à une demande de réduction d'un taux d'erreur de l'opération de décodage.

12. Procédé selon l'une quelconque des revendications 7 à 11, la mise à jour des valeurs statistiques sur la base des valeurs statistiques et des valeurs statistiques d'une itération de décodage précédente stockées dans une mémoire du décodeur comprenant la mise à jour en parallèle de différents ensembles de valeurs statistiques attribuées à différents bits de parité.

13. Support lisible par une machine comprenant des instructions lisibles par une machine qui, lorsqu'elles sont exécutées par la machine, amènent la machine à exécuter le procédé selon l'une quelconque des revendications 7 à 12.
